# EUROPEAN PATENT SPECIFICATION

(11) **EP 2 410 473 B1**
(45) Date of publication and mention of the grant of the patent: **29.10.2014**
(21) Application number: 11182911.5
(22) Date of filing: 06.03.2007
(51) Int. Cl.: G06K 19/077, G06K 19/07, H05K 1/16, G09F 3/00, H05K 1/02, H01Q 7/00, H01Q 11/08, H01Q 1/22

(54) **Article with an electromagnetic-coupling module**
Artikel mit elektromagnetisch gekoppeltem Modul
Article doté d'un module de couplage électromagnétique

(30) Priority: 26.04.2006 JP 2006122487; 30.06.2006 JP 2006182686; 25.12.2006 JP 2006347460
(43) Date of publication of application: 25.01.2012
(62) Divisional of application: 07737818.0
(73) Proprietor: Murata Manufacturing Co., Ltd., Kyoto 617-8555 (JP)
(72) Inventor: Kato, Noboru, Nagaokakyo-shi Kyoto 617-8555 (JP); Kimura, Ikuhei, Nagaokakyo-shi Kyoto 617-8555 (JP); Iwasaki, Kimikazu, Nagaokakyo-shi Kyoto 617-8555 (JP); Ishino, Satoshi, Nagaokakyo-shi Kyoto 617-8555 (JP)
(74) Representative: Zimmermann, Tankred Klaus

(56) References cited:
- WO-A1-91/02386
- US-A1- 2005 054 399
- US-A1- 2006 043 198

## Description

### Technical Field

The present invention relates to an article with an electromagnetic-coupling module and more particularly, to an article with an electromagnetic-coupling module including a wireless IC chip used in an RFID (Radio Frequency Identification) system.

### Background Art

In recent years, as article management systems, RFID systems, in which communication is performed by a non-contact method between a reader/writer that generates an induced electromagnetic field and an IC tag (hereinafter referred to as a "wireless IC device") storing predetermined information attached to an article in order to exchange information, have been developed. As wireless IC devices used for the RFID systems, for example, wireless IC devices disclosed in Patent Documents 1 and 2 have been known.

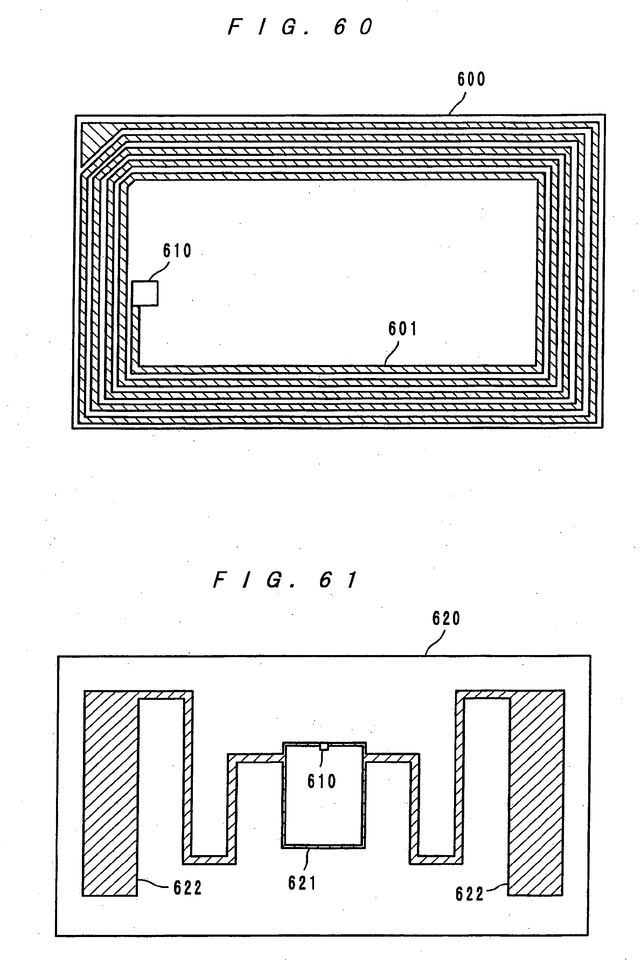

As shown in Fig. 60, a wireless IC device, in which an antenna pattern 601 is provided on a plastic film 600, and a wireless IC chip 610 is attached to one end of the antenna pattern 601, is provided. As shown in Fig. 61, a wireless IC device, in which an antenna pattern 621 and radiation electrodes 622 are provided on a plastic film 620, and the wireless IC chip 610 is attached at a predetermined place of the antenna pattern 621, is provided.

However, in the conventional wireless IC devices, the wireless IC chip 610 is directly connected to and mounted on the antenna pattern 601 or 621 by using an Au bump for electrical connection. Therefore, it is necessary to position a very small wireless IC chip 610 on the film 600 or 620 having a large area. However, mounting the very small wireless IC chip 610 on the large film 600 or 620 is extremely difficult and has a problem that position deviation occurring at the time of mounting will change resonance frequency characteristics of the antenna. Furthermore, resonance frequency characteristics of the antenna also change if the antenna pattern 601 or 621 is rounded or sandwiched between dielectrics (for example, inserted in a book).

Applications of wireless IC devices are limitless. At present, however, since the resonance frequency characteristics of an antenna change depending on how the antenna is disposed, it is difficult to attach wireless IC devices to various articles.
Patent Document 1: Japanese Unexamined Patent Application Publication No. 2005-136528
Patent Document 2: Japanese Unexamined Patent Application Publication No. 2005-244778

US 2006/043198 A1 describers an RFID device, such as an RFID tag or label, which includes a combined reactive coupler electrically coupling a transponder chip to an antenna. The combined reactive coupler includes a magnetic coupler and a capacitive coupler. The magnetic coupler and the reactive coupler may have respective coupling elements on both the interposer and on an antenna substrate.

WO 91/02386 A1 describes an antenna for a transmitter and a receiver of a portable radio appliance, which consists essentially of two sheet metal angles arranged side by side. One of the two elements is excited with high-frequency currents by means of a coaxial supply line. The second sheet metal angle is excited through radiation coupling by the first sheet metal angle. The sheet metal angles are aligned in the same direction and the distance between them in the end region is considerably less than in the bent edge of the apex line.

US 2005/054399 A1 describes a radio communication device, which includes a metallized housing and an antenna. The metallized housing includes an antenna bandwidth enhancement slot that causes multiple electrical paths to be generated for the dense surface currents found on the metallized housing. Hence, multiple resonances are introduced to the antenna.

### Summary of the Invention

An object of the present invention is to provide an article with an electromagnetic-coupling module including a wireless IC chip and having stable frequency characteristics.

This object is achieved by an article of claim 1.

In order to achieve the above-described object, an article with an electromagnetic-coupling module according to the present invention comprises an article and an electromagnetic-coupling module. The electromagnetic-coupling module includes a wireless IC chip, and a feeder circuit board on which the wireless IC chip is mounted and in which a feeder circuit including a resonance circuit having a predetermined resonance frequency is provided. The article includes a radiation plate for radiating a transmission signal supplied from the feeder circuit of the electromagnetic-coupling module via electromagnetic coupling and/or for supplying a received reception signal to the feeder circuit via electromagnetic coupling.

In the article with an electromagnetic-coupling module according to the present invention, the wireless IC chip is mounted on the feeder circuit board and is integrated with the radiation plate via the feeder circuit board. Since the feeder circuit board has a very small area compared with the radiation plate, the wireless IC chip can be mounted on the feeder circuit board at extremely high accuracy.

The frequency of a transmission signal radiated from the radiation plate and the frequency of a received signal to be supplied to the wireless IC chip are substantially determined by the resonance frequency of the resonance circuit in the feeder circuit board. "The frequencies are substantially determined" means that the frequencies may shift slightly due to a position relationship between the feeder circuit board and the radiation plate. That is, since the frequencies of the transmission/received signals are determined in the feeder circuit board on which the wireless IC chip is mounted at high accuracy, the frequency characteristics do not change regardless of the shape, the size, the position and the like of the radiation plate. For example, even if the radiation plate is rolled or sandwiched between dielectrics, the frequency characteristics do not change, and stable frequency characteristics can be obtained. Therefore, it is possible to incorporate various types of articles in an RFID system.

In the article with an electromagnetic-coupling module according to the present invention, the radiation plate may be a metal member that is originally part of the article itself. For example, if the article is a mobile terminal device, a metal housing thereof can be used as a radiation plate.

The wireless IC chip not only stores information of an article to which the electromagnetic-coupling module is attached but also can rewrite the information, and may have an information processing function other than that of an RFID system.

In the article with an electromagnetic-coupling module according to the present invention, the resonance circuit is preferably a lumped-constant resonance circuit formed of a capacitor element and an inductor element. The lumped-constant resonance circuit may be an LC parallel resonance circuit or an LC series resonance circuit, or may be configured to include a plurality of LC series resonance circuits or a plurality of LC parallel resonance circuits. The resonance circuit can also be configured as a distributed-constant resonance circuit. In that case, the inductor of the resonance circuit is configured by a strip line. However, if the resonance circuit is configured as a lumped-constant resonance circuit formed of a capacitor element and an inductor element, size reduction can be easily achieved, and the resonance circuit is less affected by other elements such as the radiation plate. If the resonance circuit includes a plurality of resonance circuits, the resonance circuits are coupled with one another, and the band of the transmission signal is widened.

Furthermore, when the capacitor element is disposed downstream of the wireless IC chip and between the wireless IC chip and the inductor element, surge resistant is improved. Since a surge is a low-frequency electric current up to 200 MHz, the surge can be cut by a capacitor, and surge destruction of the wireless IC chip can be prevented.

The feeder circuit board may be a multilayer board in which a plurality of dielectric layers or magnetic layers are stacked. In this case, the capacitor element and the inductor element are formed on the surface of and/or inside the multilayer board. By configuring the resonance circuit by a multilayer board, elements (an electrode pattern, etc.) constituting the resonance circuit can be formed not only on the surface of the board but also inside the board, thereby making it possible to downsize the board. The layout flexibility of the resonance circuit elements is increased, and higher performance of the resonance circuit can also be achieved. The multilayer board may be a resin multilayer board obtained by stacking a plurality of resin layers or may be a ceramic multilayer board obtained by stacking a plurality of ceramic layers. Furthermore, the multilayer board may be a thin-film multilayer board using a thin-film forming technology. When the multilayer board is a ceramic multilayer board, it is preferable that the ceramic layer be formed using a low-temperature sintered ceramic material. This is because silver or copper having a low resistance can be used as a resonance circuit member.

On the other hand, the feeder circuit board may be a single-layer board of a dielectric or a magnetic material. In this case, the capacitor element and/or the inductor element are formed on the surface of a single-layer board. The material of the single-layer board may be resin or ceramic. The capacitance of the capacitor element may be formed between planar-shaped electrodes formed on the obverse and reverse surfaces of the single-layer board, or can be formed between electrodes arranged side by side on one surface of the single-layer board.

The feeder circuit board is preferably a rigid resin or ceramic board. If the board is rigid, even when the wireless IC device is bonded to an object of any shape, the frequency of the transmission signal is stabilized. Furthermore, the wireless IC chip can be stably mounted on the rigid board.

The electric length of the radiation plate is preferably an integral multiple of a half wavelength of the resonance frequency, and the gain becomes maximum. However, since the frequency is substantially determined by the resonance circuit, the electric length of the radiation plate does not necessarily need to be an integral multiple of a half wavelength of the resonance frequency. This is a major advantage as compared with a case in which the radiation plate is an antenna element having a specific resonance frequency.

Furthermore, for the connection between the wireless IC chip and the feeder circuit board, various forms can be adopted. For example, a chip-side electrode pattern may be provided in the wireless IC chip, and a first board-side electrode pattern may be provided on the feeder circuit board, and the chip-side electrode pattern is directly connected electrically to the first board-side electrode pattern. In this case, they can be connected using solder, a conductive resin, an Au bump, or the like.

The chip-side electrode pattern and the first board-side electrode pattern may be connected by means of capacitive coupling or magnetic coupling. If the connection is made by capacitive coupling or magnetic coupling, solder or conductive resin does not need to be used, and the wireless IC chip can be bonded to the board using an adhesive agent such as resin. In this case, the chip-side electrode pattern and the first board-side electrode pattern do not need to be formed on the surface of the wireless IC chip or on the surface of the feeder circuit board. For example, a resin film may be formed on the surface of the chip-side electrode pattern, or the first board-side electrode pattern may be formed in an internal layer of the multilayer board.

In the case of using capacitive coupling, the area of the first board-side electrode pattern is preferably larger than the area of the chip-side electrode pattern. Even if the position accuracy at the time of mounting the wireless IC chip on the feeder circuit board varies slightly, variations in the capacitance formed between the two electrode patterns are reduced. Moreover, although it is difficult to form a large electrode pattern on a small wireless IC chip, it is not difficult to form a large electrode pattern on the feeder circuit board since the board is comparatively large.

In the case of using magnetic coupling, as compared with capacitive coupling, the mounting accuracy of a wireless IC chip on the feeder circuit board is not so high, and therefore, the mounting is further facilitated. Each of the chip-side electrode pattern and the first board-side electrode pattern is preferably a coil-shaped electrode pattern. The design of a coil-shaped electrode pattern such as a spiral shape or a helical shape is easy. If the frequency is high, a meandering pattern is effective.

On the other hand, for the connection between the feeder circuit board and the radiation plate, various forms can be adopted. For example, a second board-side electrode pattern and a radiation plate may be connected by capacitive coupling or by magnetic coupling. If the connection is made by capacitive coupling or by magnetic coupling, it is not necessary to use solder or conductive resin, the feeder circuit board may be bonded to the radiation plate using an adhesive agent such as resin. In this case, the second board-side electrode pattern does not need to be formed on the surface of the feeder circuit board. For example, the second board-side electrode pattern may be formed in an internal layer of the multilayer board.

In the case of using magnetic coupling, the second board-side electrode pattern is preferably a coil-shaped electrode pattern. Since it is easy to control magnetic flux with a coil-shaped electrode pattern of a spiral or helical shape, the design is easy. If the frequency is high, a meandering pattern can be used. In the case of using magnetic coupling, it is preferable not to prevent a change in magnetic flux caused in the second board-side electrode pattern (coil-shaped electrode pattern). For example, it is preferable that an opening be formed in the radiation plate. As a result, the transfer efficiency of signal energy is improved and also, a shift of frequency due to the bonding between the feeder circuit board and the radiation plate can be reduced.

### Advantages

According to the present invention, a wireless IC chip can be mounted on a feeder circuit board at extremely high accuracy. Furthermore, since the frequencies of a transmission signal and a received signal are determined by the feeder circuit provided in the feeder circuit board, even if an electromagnetic-coupling module is combined with a radiation plate of various forms, frequency characteristics do not change, and stable frequency characteristics can be obtained. Therefore, by using a metal that is originally possessed by an article or a metal pattern attached to an article as a radiation plate, it is possible to incorporate various articles in an RFID system, and it is possible to perform asset management of the articles.

### Brief Description of the Drawings

Fig. 1 is a perspective view showing a first example of an electromagnetic-coupling module.
Fig. 2 is a sectional view of the first example.
Fig. 3 is an equivalent circuit diagram of the first example.
Fig. 4 is an exploded perspective view showing a feeder circuit board of the first example.
Figs. 5(A) and 5(B) are perspective views showing a connection state between a wireless IC chip and the feeder circuit board.
Fig. 6 is a perspective view showing a second example of the electromagnetic-coupling module.
Fig. 7 is a perspective view showing a third example of the electromagnetic-coupling module.
Fig. 8 is a sectional view showing a fourth example of the electromagnetic-coupling module.
Fig. 9 is an equivalent circuit diagram showing a fifth example of the electromagnetic-coupling module.
Fig. 10 is an equivalent circuit diagram showing a sixth example of the electromagnetic-coupling module.
Fig. 11 is an equivalent circuit diagram showing a seventh example of the electromagnetic-coupling module.
Fig. 12 is a sectional view showing an eighth example of the electromagnetic-coupling module.
Fig. 13 is an equivalent circuit diagram of the eighth example.
Fig. 14 is an exploded perspective view showing a feeder circuit board of the eighth example.
Fig. 15 is an equivalent circuit diagram showing a ninth example of the electromagnetic-coupling module.
Fig. 16 is an equivalent circuit diagram showing a tenth example of the electromagnetic-coupling module.
Fig. 17 is an exploded perspective view showing a feeder circuit board of the tenth example.
Fig. 18 is a perspective view showing an eleventh example of the electromagnetic-coupling module.
Fig. 19 is a sectional view showing a twelfth example of the electromagnetic-coupling module.
Fig. 20 is an exploded perspective view showing a feeder circuit board of the twelfth example.
Fig. 21 is an equivalent circuit diagram showing a thirteenth example.
Fig. 23 is an equivalent circuit diagram showing a fourteenth example of the electromagnetic-coupling module.
Fig. 24 is an exploded perspective view showing a feeder circuit board of the fourteenth example.
Fig. 25 is a graph showing reflection characteristics of the fourteenth example.
Fig. 26 is an equivalent circuit diagram showing a fifteenth example of the electromagnetic-coupling module.
Fig. 27 is an exploded perspective view showing a feeder circuit board of the fifteenth example.
Figs. 28(A) and 28(B) show a wireless IC chip of the fifteenth example, wherein Fig. 28(A) is a bottom view and Fig. 28(B) is an enlarged sectional view.
Fig. 29 is an equivalent circuit diagram showing a sixteenth example of the electromagnetic-coupling module.
Fig. 30 is an exploded perspective view showing a feeder circuit board of the sixteenth example.
Fig. 31 is an exploded perspective view showing a seventeenth example of the electromagnetic-coupling module.
Fig. 32 is a bottom view of a feeder circuit board of the seventeenth example, on which a wireless IC chip is mounted.
Fig. 33 is a side view of the seventeenth example.
Fig. 34 is a side view showing a modification of the seventeenth example.
Fig. 35 is an exploded perspective view showing an eighteenth example of the electromagnetic-coupling module.
Fig. 36 is a perspective view showing a first example of an article with an electromagnetic-coupling module.
Fig. 37 is a perspective view showing a second example of the article with an electromagnetic-coupling module.
Fig. 38 is a front view showing a third example of the article with an electromagnetic-coupling module.
Fig. 39 is a perspective view showing a fourth example of the article with an electromagnetic-coupling module .
Fig. 40 is a perspective view showing a fifth example of the article with an electromagnetic-coupling module.
Fig. 41 is a perspective view showing an embodiment of the article with an electromagnetic-coupling module according to the present invention.
Fig. 42 is a perspective view showing a sixth example of the article with an electromagnetic-coupling module .
Fig. 43 is a perspective view showing an seventh example of the article with an electromagnetic-coupling module .
Fig. 44 is a front view showing a eighth example of the article with an electromagnetic-coupling module.
Fig. 45 is a perspective view showing a ninth example of the article with an electromagnetic-coupling module.
Fig. 46 is a plan view showing an tenth example of the article with an electromagnetic-coupling module.
Fig. 47 is a perspective view showing a eleventh example of the article with an electromagnetic-coupling module.
Fig. 48 is a perspective view showing a twelfth example of the article with an electromagnetic-coupling module.
Fig. 49 is a perspective view showing a thirteenth example of the article with an electromagnetic-coupling module.
Fig. 50 is a perspective view showing a fourteenth example of the article with an electromagnetic-coupling module.
Fig. 51 is a perspective view showing a fifteenth example of the article with an electromagnetic-coupling module.
Fig. 52 is a perspective view showing a sixteenth example of the article with an electromagnetic-coupling module.
Fig. 53 is a perspective view showing an seventeenth example of the article with an electromagnetic-coupling module.
Fig. 54 is a perspective view showing a eighteenth example of the article with an electromagnetic-coupling module.
Fig. 55 is a perspective view showing a nineteenth example of the article with an electromagnetic-coupling module .
Fig. 56 is a perspective view showing a twentieth example of the article with an electromagnetic-coupling module.
Fig. 57 is a perspective view showing a twenty-first example of the article with an electromagnetic-coupling module.
Fig. 58 is a front view showing a twenty-second example of the article with an electromagnetic-coupling module.
Fig. 59 is a perspective view showing a twenty-third example of the article with an electromagnetic-coupling module.
Fig. 60 is a plan view showing a first example of a conventional wireless IC device.
Fig. 61 is a plan view showing a second example of a conventional wireless IC device.

### Best Mode for Carrying Out the Invention

Embodiments of an article with an electromagnetic-coupling module according to the present invention will be described below with reference to the attached drawings. Common components and parts of various electromagnetic-coupling modules and various articles to be described below are designated with the same reference numerals, and repetitious descriptions thereof are omitted.

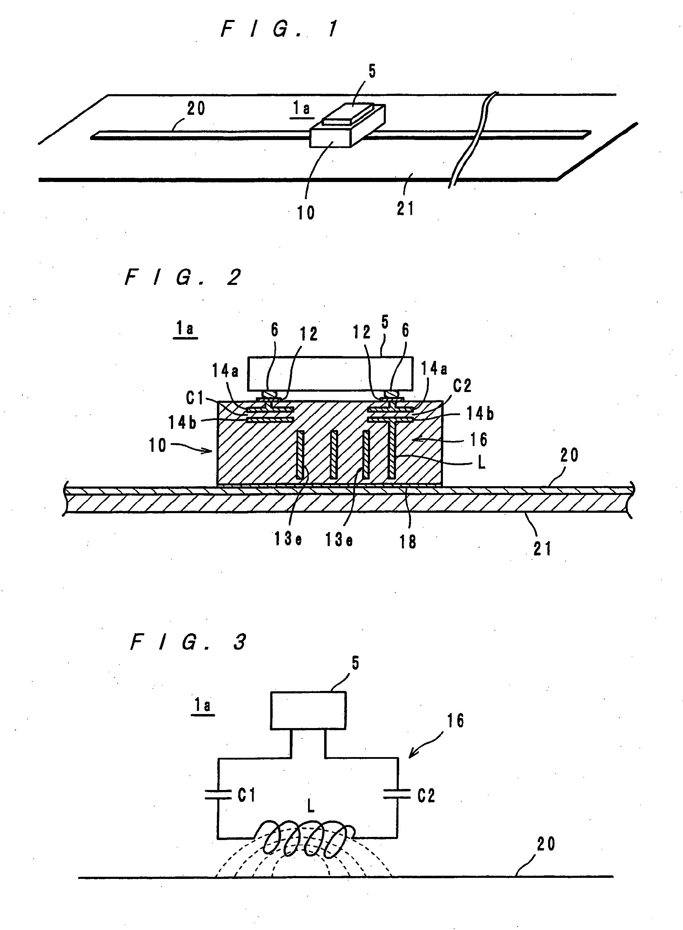

### (First example of Electromagnetic-Coupling Module, See Figs. 1 to 5)

An electromagnetic-coupling module 1a of a first example is combined with a monopole-type radiation plate 20. As shown in Figs. 1 and 2, the electromagnetic-coupling module 1a includes a wireless IC chip 5 and a feeder circuit board 10 with the wireless IC chip 5 mounted on the top surface, and is bonded to the radiation plate 20. The wireless IC chip 5 includes a clock circuit, a logic circuit, and a memory circuit in which necessary information is memorized. The wireless IC chip 5 is directly connected electrically to a feeder circuit 16 contained in the feeder circuit board 10.

The feeder circuit 16 is a circuit for supplying a transmission signal having a predetermined frequency to the radiation plate 20 and/or a circuit for selecting a received signal having a predetermined frequency from signals received by the radiation plate 20 and supplying the selected signals to the wireless IC chip 5. The feeder circuit 16 includes a resonance circuit that resonates at the frequency of transmission/received signals.

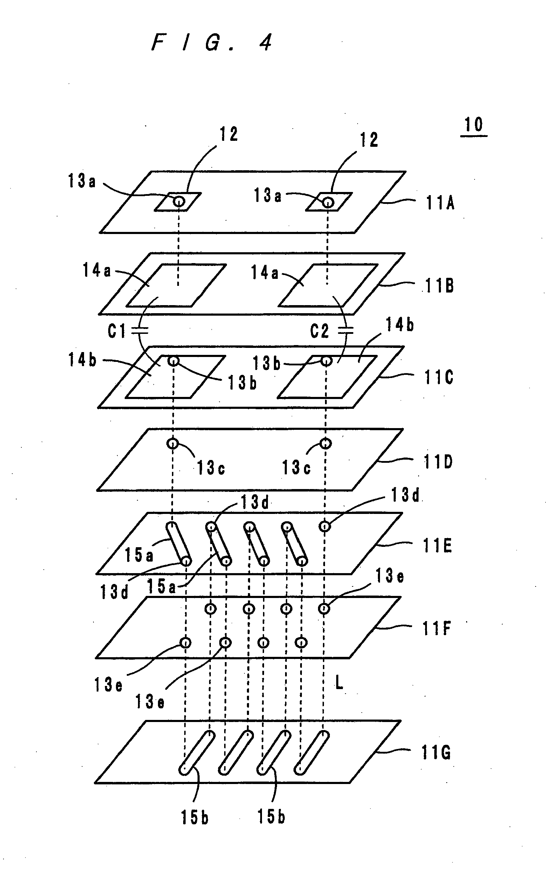

In the feeder circuit board 10, as shown in Figs. 2 and 3, the feeder circuit 16 is defined by a lumped-constant-type LC series resonance circuit formed of a helical inductance element L and capacitance elements C1 and C2. More specifically, as shown in Fig. 4, the feeder circuit board 10 is obtained by laminating, press-bonding and sintering ceramic sheets 11A to 11G made of a dielectric. The feeder circuit board 10 includes a sheet 11A on which connection electrodes 12 and viahole conductors 13a are formed; a sheet 11B on which capacitor electrodes 14a are formed; a sheet 11C on which capacitor electrodes 14b and viahole conductors 13b are formed; a sheet 11D on which viahole conductors 13c are formed; a sheet 11E on which conductor patterns 15a and viahole conductors 13d are formed; a sheet 11F (one or more) on which viahole conductors 13e are formed; and a sheet 11G on which conductor patterns 15b are formed. Each of the ceramic sheets 11A to 11G may be a sheet made of a magnetic ceramic material. The feeder circuit board 10 can be easily obtained by conventionally used processes for manufacturing a multilayer board, such as a sheet stacking method and a thick-film printing method.

As a result of stacking the above sheets 11A to 11G, the inductance element L whose helical winding axis is parallel to the radiation plate 20, and the capacitance elements C1 and C2 are formed. The capacitor electrode 14b is connected to both ends of the inductance element L, and the capacitor electrodes 14a are connected to the connection electrodes 12 via the viahole conductors 13a. Then, the connection electrodes 12, which serve as a board-side electrode pattern, are directly connected to a chip-side electrode pattern (not shown) of the wireless IC chip 5 via solder bumps 6 for electrical connection.

That is, a transmission signal is fed to the radiation plate 20 via a magnetic field from the inductance element L that is a coil-shaped electrode pattern, among the elements constituting the feeder circuit. Furthermore, a signal received from the radiation plate 20 is fed to the inductance element L via a magnetic field. To this end, in the feeder circuit board 10, preferably, the inductance element and the capacitance element constituting the resonance circuit are arranged such that the inductance element is nearer the radiation plate 20.

In this example, the radiation plate 20 is a long plate made of a non-magnetic material, such as aluminum foil or copper foil, that is, an open-ended metal material. The radiation plate 20 is formed on an article having a base of an insulating flexible resin film 21, such as PET. The feeder circuit board 10 is bonded to the radiation plate 20 via an insulating adhesive layer which is an adhesive agent 18 applied to the bottom of the feeder circuit board 10.

An example in terms of their size will be given. The thickness of the wireless IC chip 5 is 50 µm to 100 µm. The thickness of the solder bumps 6 is approximately 20 µm. The thickness of the feeder circuit board 10 is 200 µm to 500 µm. The thickness of the adhesive agent 18 is 0.1 µm to 10 µm. The thickness of the radiation plate 20 is 1 µm to 50 µm. The thickness of the film 21 is 10 µm to 100 µm.

The size (area) of the wireless IC chip 5 has various values, such as 0.4 mm × 0.4 mm and 0.9 mm × 0.8 mm. The size (area) of the feeder circuit board 10 can range from the same size as that of the wireless IC chip 5 to approximately 3 mm × 3 mm.

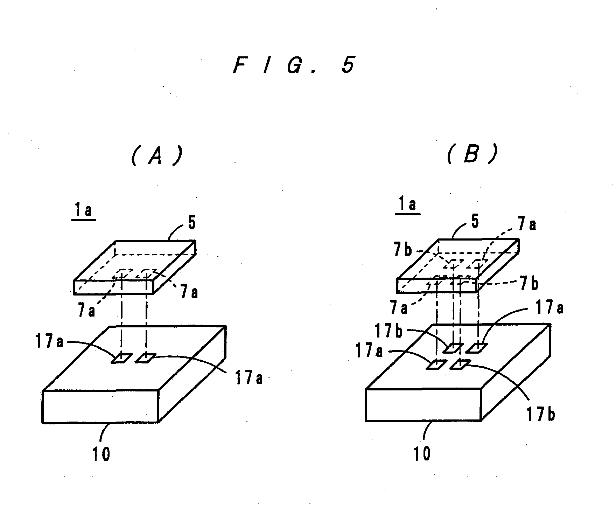

Fig. 5 shows connection arrangement between the wireless IC chip 5 and the feeder circuit board 10. Fig. 5(A) shows an arrangement in which pairs of antenna (balance) terminals 7a and 17a are formed on the reverse surface of the wireless IC chip 5 and on the obverse surface of the feeder circuit board 10. Fig. 5(B) shows another arrangement in which in addition to the pairs of antenna (balance) terminals 7a and 17a, ground terminals 7b and 17b are provided on the reverse surface of the wireless IC chip 5 and on the obverse surface of the feeder circuit board 10. However, the ground terminals 17b on the surface of the feeder circuit board 10 are terminated and are not connected to other elements in the feeder circuit board 10.

Fig. 3 shows an equivalent circuit of the electromagnetic-coupling module 1a. In the electromagnetic-coupling module 1a, a high-frequency signal (for example, a UHF frequency band) emitted from a reader/writer (not shown) is received by the radiation plate 20, and the feeder circuit 16 (the LC series resonance circuit formed of the inductance element L and the capacitance elements C1 and C2) that is mainly magnetically coupled with the radiation plate 20 is caused to resonate. Thereby, a received signal at a predetermined frequency band is supplied to the wireless IC chip 5. On the other hand, predetermined energy is extracted from the received signal, and at the feeder circuit 16, by using the energy as a driving source, the information memorized in the wireless IC chip 5 is matched with a predetermined frequency. Thereafter, a transmission signal is transmitted from the inductance element L of the feeder circuit 16 to the radiation plate 20 via magnetic coupling, and is transmitted and transferred from the radiation plate 20 to the reader/writer.

The coupling between the feeder circuit 16 and the radiation plate 20 is mainly coupling via a magnetic field. However, coupling via an electric field may exist. In the present invention, "electromagnetic coupling" means coupling via an electric field and/or a magnetic field.

In the electromagnetic-coupling module 1a of the first example, the wireless IC chip 5 is directly connected electrically to the feeder circuit board 10 containing the feeder circuit 16, and the feeder circuit board 10 has almost the same area as that of the wireless IC chip 5 and is rigid. Therefore, as compared with a conventional case in which the wireless IC chip 5 is mounted on a large flexible film, the wireless IC chip 5 can be positioned and mounted extremely accurately. Moreover, since the feeder circuit board 10 is made of a ceramic material and has a heat resistance characteristic, it is possible to solder the wireless IC chip 5 to the feeder circuit board 10. That is, since an ultra-sonic bonding method is not used, unlike the conventional case, the cost is reduced, and there is no risk that the wireless IC chip 5 is damaged by pressure applied at the time of ultra-sonic bonding. Further, it is possible to use a self-alignment effect resulting from a solder reflow.

In the feeder circuit 16, resonance frequency characteristics are determined by a resonance circuit formed of the inductance element L and the capacitance elements C1 and C2. The resonance frequency of a signal emitted from the radiation plate 20 substantially corresponds to the self-resonance frequency of the feeder circuit 16, and the maximum gain of the signal is substantially determined by at least one of the size and shape of the feeder circuit 16 and the distance and medium between the feeder circuit 16 and the radiation plate 20. More specifically, in the first example, the electrical length of the radiation plate 20 is set to 1/2 of the resonance frequency λ. However, the electrical length of the radiation plate 20 may not be an integral multiple of λ /2. That is, in the present invention, since the frequency of the signal emitted from the radiation plate 20 is substantially determined by the resonance frequency of the resonance circuit (the feeder circuit 16), frequency characteristics do not substantially depend on the electrical length of the radiation plate 20. When the electrical length of the radiation plate 20 is an integral multiple of λ/2, the gain becomes maximum, which is desirable.

In the manner described above, since the resonance frequency characteristics of the feeder circuit 16 are determined by the resonance circuit formed of the inductance element L and the capacitance elements C1 and C2 contained in the feeder circuit board 10, the resonance frequency characteristics do not change even if the electromagnetic-coupling module 1a is inserted in a book. Furthermore, even if the shape of the radiation plate 20 is changed by rounding the electromagnetic-coupling module 1a or even if the size of the radiation plate 20 is changed, the resonance frequency characteristics do not change. Furthermore, since the coil-shaped electrode pattern constituting the inductance element L is formed in such a manner that the winding axis thereof is parallel to the radiation plate 20, the electromagnetic-coupling module 1a has the advantage that the center frequency does not change. Furthermore, since the capacitance elements C1 and C2 are inserted downstream of the wireless IC chip 5, the elements C1 and C2 to cut surge at a low frequency band, and it is possible to protect the wireless IC chip 5 against surge.

Furthermore, since the feeder circuit board 10 is a rigid multilayer board, it is easy to handle for soldering of the wireless IC chip 5. Moreover, since the radiation plate 20 is a flexible metal film, for example, it is possible to form the radiation plate 20 on a wrapping film for clothes or on the surface of a columnar body, such as a plastic bottle, without difficulty.

In the present invention, the resonance circuit may also serve as a matching circuit for matching the impedance of the wireless IC chip with the impedance of the radiation plate. Alternatively, the feeder circuit board may further include a matching circuit, which is formed of an inductance element and a capacitance element, separately from the resonance circuit. If the function of the matching circuit is added to the resonance circuit, the design of the resonance circuit tends to be complicated. If the matching circuit is provided separately from the resonance circuit, the resonance circuit and the matching circuit can be designed independently of each other.

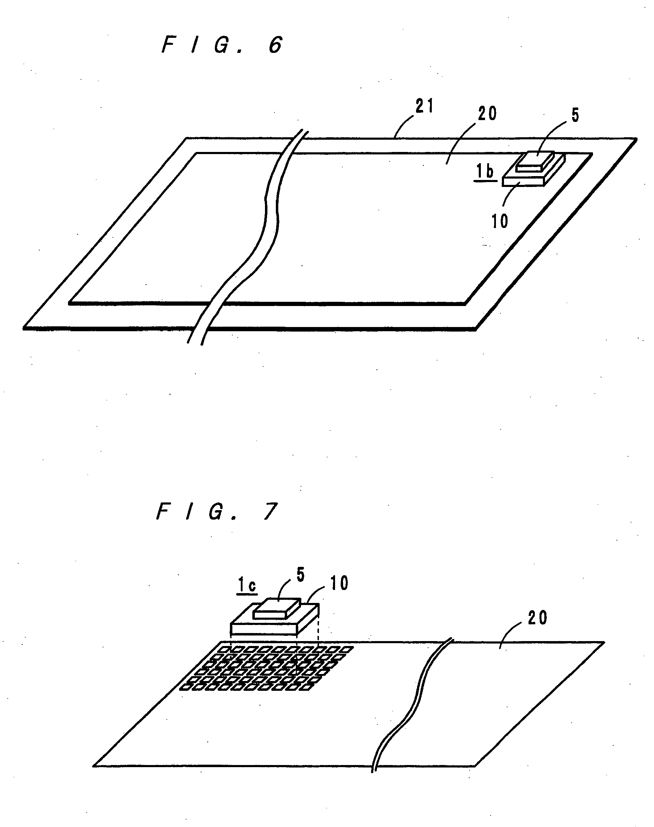

### (Second Example of Electromagnetic-Coupling Module, See Fig. 6)

As shown in Fig. 6, an electromagnetic-coupling module 1b of a second example is mounted on a radiation plate 20 made of aluminum foil having a large area, and the radiation plate 20 is fixed on an article having a base made of a flexible insulating plastic film 21 having a large area. The feeder circuit board 10 with a wireless IC chip 5 mounted thereon is bonded at an arbitrary position of the radiation plate 20.

The configuration of the electromagnetic-coupling module 1b, that is, the internal configuration of the feeder circuit substrate 10, is the same as that of the first example. Therefore, the operation and effect of the second example are basically the same as those of the first example. Further, the electromagnetic-coupling module 1b has an advantage that high accuracy is not necessary for positioning of the feeder circuit board 10 on the radiation plate 20.

### (Third Example of Electromagnetic-Coupling Module, See Fig. 7)

As shown in Fig. 7, an electromagnetic-coupling module 1c of a third example is mounted on a meshed part of a large radiation plate 20 made of aluminum foil. The mesh may be formed on the entire surface of the radiation plate 20 or may be formed on part of the radiation plate 20.

The configuration of the electromagnetic-coupling module is the same as that of the second example. In addition to the advantage that high accuracy is not required for the positioning of the feeder circuit board 10 on the radiation plate 20, since the magnetic flux of the coil-shaped electrode pattern passes through the openings of the mesh, changes (decreases) of the magnetic flux generated from the feeder circuit board 10 are decreased, and a larger amount of magnetic flux can pass through the radiation plate 20. Therefore, it is possible to improve the transfer efficiency of signal energy, and it is also possible to reduce a shift of frequency due to laminating.

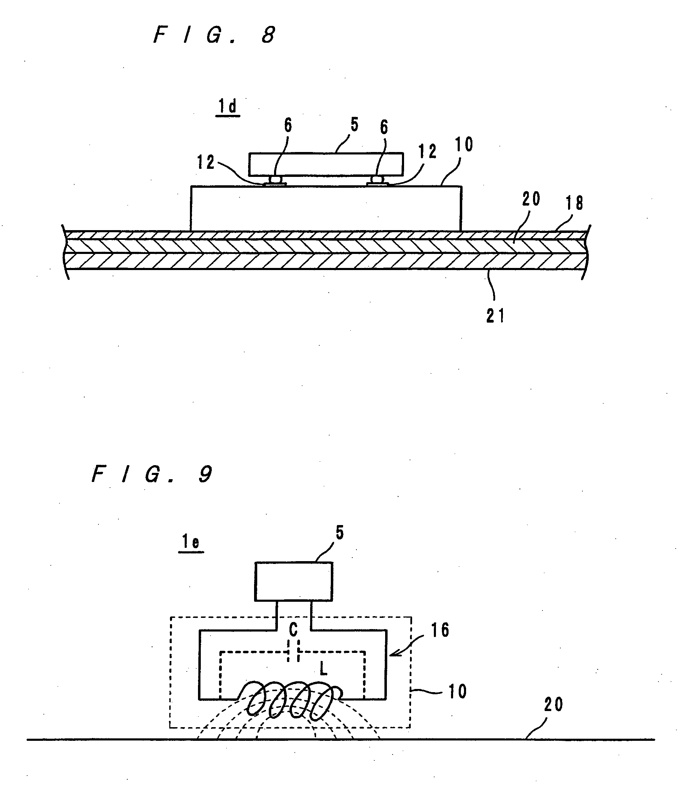

### (Fourth Example of Electromagnetic-Coupling Module, See Fig. 8)

As shown in Fig. 8, in an electromagnetic-coupling module 1d, an adhesive agent 18 is applied to the film 21, which is a base of the article to which the electromagnetic-coupling module 1d is attached, on the surface on which the feeder circuit board 10 is mounted, including the bonding position of the board 10 and other portions (here, on the entire surface). The adhesive agent 18 enables an article including the electromagnetic-coupling module 1d to be bonded to another article with the electromagnetic-coupling module 1d inside.

The configuration of the electromagnetic-coupling module 1d, that is, the internal configuration of the feeder circuit board 10, is the same as that of the first example. Therefore, the operation and effect of the fourth example are basically the same as those of the first example.

### (Fifth Example of Electromagnetic-Coupling Module, See Fig. 9)

As shown as an equivalent circuit in Fig. 9, an electromagnetic-coupling module 1e of a fifth example includes an inductance element L defined by a coil-shaped electrode pattern as a feeder circuit 16 in a feeder circuit board 10. A capacitance element C constituting an LC parallel resonance circuit is formed as a floating capacitance (distributed-constant-type capacitance) between conductor patterns of the inductance element L.

That is, even in the case of one coil-shaped electrode pattern, if it has self-resonance, the L component of the coil-shaped electrode pattern and the C component that is a floating capacitance between wires form an LC parallel resonance circuit to configure the feeder circuit 16. Therefore, in the electromagnetic-coupling module 1e, a high-frequency signal (for example, a UHF frequency band) emitted from a reader/writer (not shown) is received at the radiation plate 20, and the feeder circuit 16 (the LC parallel resonance circuit formed of an inductance element L and a capacitance element C) that is mainly magnetically coupled with the radiation plate 20 is caused to resonate. Thereby, a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance element L of the feeder circuit 16 to the radiation plate 20 via magnetic coupling. Then, the transmission signal is transmitted and transferred from the radiation plate 20 to the reader/writer.

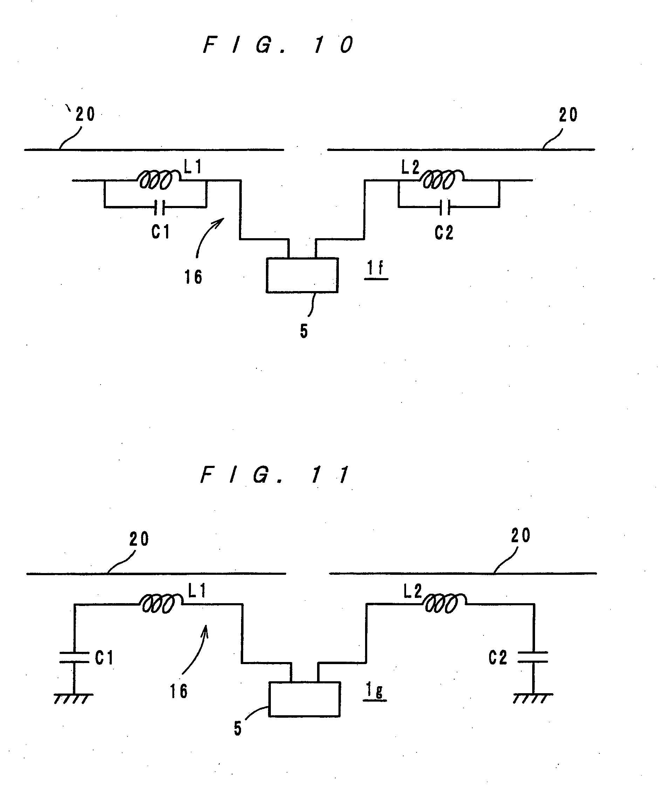

### (Sixth Example of Electromagnetic-Coupling Module, See Fig. 10)

As shown as an equivalent circuit in Fig. 10, an electromagnetic-coupling module 1f of a sixth example includes a feeder circuit 16 compatible with dipole-type radiation plates 20. The feeder circuit 16 is formed of two LC parallel resonance circuits contained in a feeder circuit board. An inductance element L1 and a capacitance element C1 are connected to a first port side of the wireless IC chip 5, and an inductance element L2 and a capacitance element C2 are connected to a second port side of the wireless IC chip 5. The pairs of the inductance element and the capacitance element face the radiation plates 20, respectively. The inductance element L1 and the capacitance element C1 have open ends. The first port and the second port constitute I/O of a differential circuit.

The operation and effect of the sixth example are basically the same as those of the first example. That is, in the electromagnetic-coupling module 1f, a high-frequency signal (for example, a UHF frequency band) emitted from a reader/writer (not shown) is received at the radiation plates 20, and the feeder circuit 16 (the LC parallel resonance circuit formed of the inductance element L1 and the capacitance element C1, and the LC parallel resonance circuit formed of the inductance element L2 and the capacitance element C2) that is mainly magnetically coupled with the radiation plates 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plates 20 via magnetic coupling. Then, the transmission signal is transmitted and transferred from the radiation plate 20 to the reader/writer.

### (Seventh Example of Electromagnetic-Coupling Module, See Fig. 11)

As shown as an equivalent circuit in Fig. 11, an electromagnetic-coupling module 1g of a seventh example includes a feeder circuit 16 compatible with dipole-type radiation plates 20. The feeder circuit 16 is formed of two LC series resonance circuits contained in a feeder circuit board. Inductance elements L1 and L2 face radiation plates 20 and 20, respectively, and capacitance elements C1 and C2 are grounded.

The operation and effect of the seventh example are basically the same as those of the first example. That is, in the electromagnetic-coupling module 1g, a high-frequency signal (for example, a UHF frequency band) emitted from a reader/writer (not shown) is received at the radiation plates 20, and the feeder circuit 16 (the LC series resonance circuit formed of the inductance element L1 and the capacitance element C1, and the LC series resonance circuit formed of the inductance element L2 and the capacitance element C2) that is mainly magnetically coupled with the radiation plates 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plates 20 via magnetic coupling. Then, the transmission signal is transmitted and transferred from the radiation plates 20 to the reader/writer.

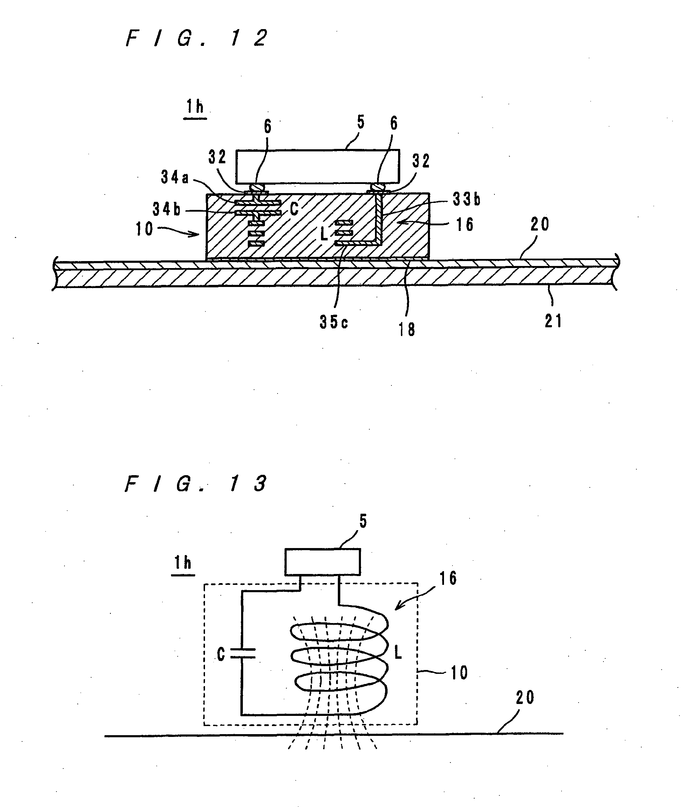

### (Eighth Example of Electromagnetic-Coupling Module, See Figs. 12 to 14)

As shown in Fig. 12, an electromagnetic-coupling module 1h of an eighth example is combined with a monopole-type radiation plate 20. The electromagnetic-coupling module 1h includes a feeder circuit 16 defined by an LC series resonance circuit formed of an inductance element L and a capacitance element C contained in a feeder circuit board 10. As shown in Fig. 13, a coil-shaped electrode pattern constituting the inductance element L has a winding axis perpendicular to the radiation plate 20, and the feeder circuit 16 is mainly magnetically coupled with the radiation plate 20.

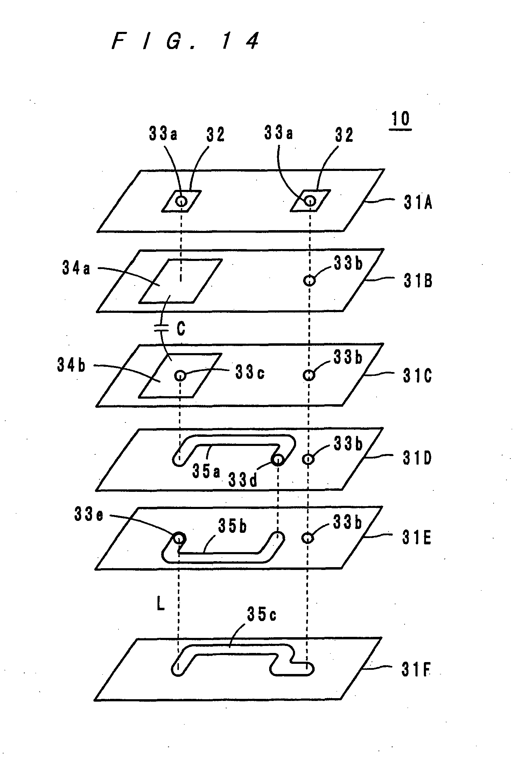

More specifically, as shown in Fig. 14, the feeder circuit board 10 is obtained by laminating, press-bonding and sintering ceramic sheets 31A to 31F made of a dielectric. The feeder circuit board 10 includes a sheet 31A on which connection electrodes 32 and viahole conductors 33a are formed; a sheet 31B on which a capacitor electrode 34a and a viahole conductor 33b are formed; a sheet 31C on which a capacitor electrode 34b and viahole conductors 33c and 33b are formed; a sheet 31D (one or more) on which a conductor pattern 35a and viahole conductors 33d and 33b are formed; a sheet 31E (one or more) on which a conductor pattern 35b and viahole conductors 33e and 33b are formed; and a sheet 31F on which a conductor pattern 35c is formed.

By stacking the above sheets 31A to 31F, the feeder circuit 16 is formed as an LC series resonance circuit, in which the inductance element L whose helical winding axis is perpendicular to the radiation plate 20 is connected in series with the capacitance element C, is obtained. The capacitor electrode 34a is connected to the connection electrode 32 via the viahole conductor 33a and is further connected to the wireless IC chip 5 via a solder bump 6. One end of the inductance element L is connected to the connection electrode 32 via the viahole conductor 33b and is further connected to the wireless IC chip 5 via a solder bump 6.

The operation and effect of the eighth example are basically the same as those of the first example. That is, in the electromagnetic-coupling module 1h, a high-frequency signal (for example, a UHF frequency band) emitted from a reader/writer (not shown) is received at the radiation plate 20, and the feeder circuit 16 (the LC series resonance circuit formed of an inductance element L and a capacitance element C) that is mainly magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance element L of the feeder circuit 16 to the radiation plate 20 via magnetic coupling. Then, the transmission signal is transmitted and transferred from the radiation plate 20 to the reader/writer.

In particular, in the eighth example, since the coil-shaped electrode pattern has a winding axis perpendicular to the radiation plate 20, the eighth example has an advantage that the magnetic flux to the radiation plate 20 increases. Consequently, the transfer efficiency of signal energy is improved, and the gain is increased.

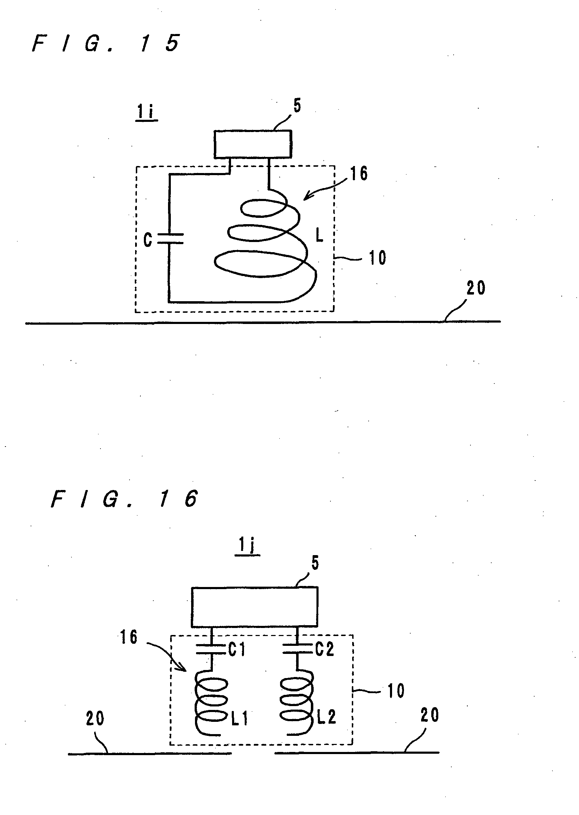

### (Ninth Example of Electromagnetic-Coupling Module, See Fig. 15)

As shown as an equivalent circuit in Fig. 15, in an electromagnetic-coupling module 1i of a ninth example, an inductance element L has a coil-shaped electrode pattern as described in the eighth example, and the coil-shaped electrode pattern has a winding width (coil diameter) which becomes gradually larger toward the radiation plate 20. Other configurations are the same as those of the eighth example.

The ninth example exhibits the same operation and effect as those of the eighth example. In addition, since the winding width (coil diameter) of the coil-shaped electrode pattern of the inductance element L is gradually larger toward the radiation plate 20, the transfer efficiency of signals is improved.

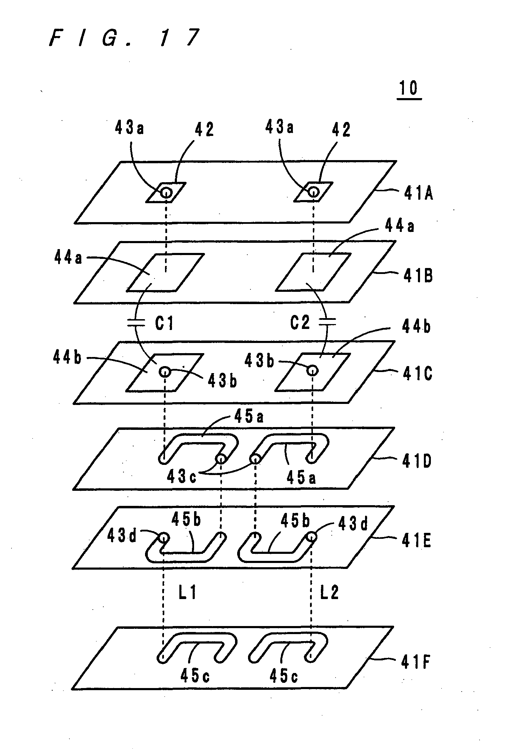

### (Tenth Example of Electromagnetic-Coupling Module, See Figs. 16 and 17)

As shown as an equivalent circuit in Fig. 16, an electromagnetic-coupling module 1j of a tenth example is compatible with dipole-type radiation plates 20 and contains a feeder circuit 16 defined by two LC series resonance circuits in a feeder circuit board 10.

More specifically, as shown in Fig. 17, the feeder circuit board 10 is obtained by laminating, press-bonding and sintering ceramic sheets 41A to 41F made of a dielectric. The feeder circuit board 10 includes a sheet 41A on which connection electrodes 42 and viahole conductors 43a are formed; a sheet 41B on which capacitor electrodes 44a are formed; a sheet 41C on which capacitor electrodes 44b and viahole conductors 43b are formed; a sheet 41D (one or more) on which conductor patterns 45a and viahole conductors 43c are formed; a sheet 41E (one or more) on which conductor patterns 45b and viahole conductors 43d are formed; and a sheet 41F on which conductor patterns 45c are formed.

By stacking the above sheets 41A to 41F, the feeder circuit 16 is defined by two LC series resonance circuits, in which the inductance elements L1 and L2 having helical winding axes perpendicular to the radiation plates 20 and are connected in series with the capacitance elements C1 and C2, respectively. The capacitor electrodes 44a are connected to the connection electrode 42 via the viahole conductors 43a and are further connected to the wireless IC chip 5 via solder bumps.

The operation and effect of the tenth example are basically the same as those of the first example. That is, in the electromagnetic-coupling module 1j, a high-frequency signal (for example, a UHF frequency band) emitted from a reader/writer (not shown) is received at the radiation plate 20, and the feeder circuit 16 (the LC series resonance circuit formed of an inductance element L1 and a capacitance element C1, and the LC series resonance circuit formed of an inductance element L2 and a capacitance element C2) that is mainly magnetically coupled with the radiation plates 20 is caused to resonate. Thereby, a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plate 20 via magnetic coupling. Then, the transmission signal is transmitted and transferred from the radiation plate 20 to the reader/writer.

Furthermore, since the capacitance elements C1 and C2 are disposed downstream of the wireless IC chip 5 and between the wireless IC chip 5 and the inductance elements L1 and L2, surge resistance is improved. Since a surge is a low-frequency electric current up to 200 MHz, it is possible to cut the surge by the capacitance elements C1 and C2, and the wireless IC chip 5 is prevented from being destroyed by the surge.

In the tenth example, the resonance circuit formed of the capacitance element C1 and the inductance element L1 is not coupled to the resonance circuit formed of the capacitance element C2 and the inductance element L2.

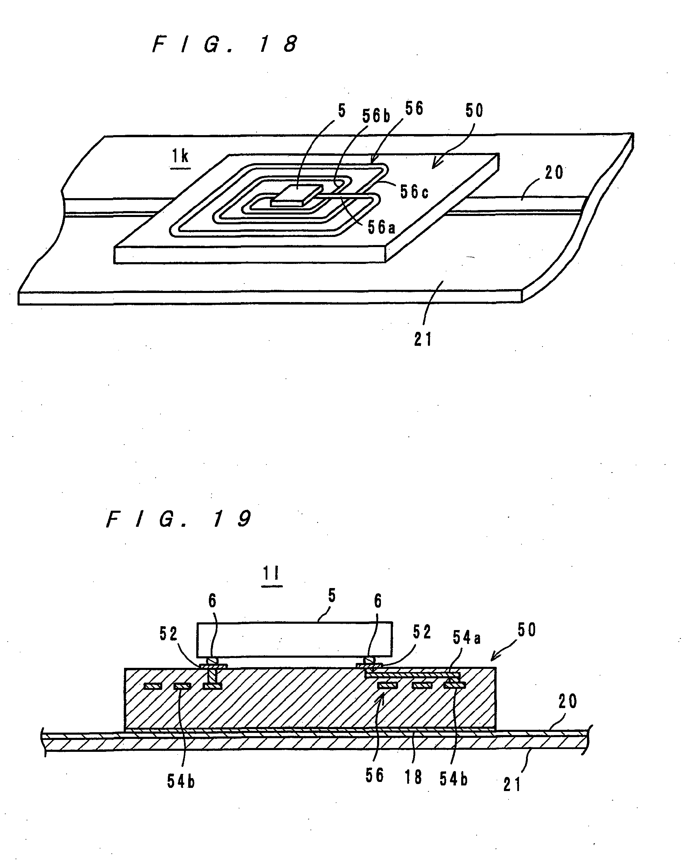

### (Eleventh Example of Electromagnetic-Coupling Module, See Fig. 18)

As shown in Fig. 18, in an electromagnetic-coupling module 1k of an eleventh example, a feeder circuit 56 defined by a coil-shaped electrode pattern, that is, a spiral inductance element is provided on the surface of a rigid single-layer feeder circuit board 50 made of ceramic or heat-resistant resin. Both ends of the feeder circuit 56 are directly connected to a wireless IC chip 5 via solder bumps, and the feeder circuit board 50 is bonded to the film 21, which holds a radiation plate 20, by using an adhesive agent. A conductor pattern 56a and conductor patterns 56b and 56c, which constitute the feeder circuit 56 and which intersect each other, are separated by an insulating film (not shown).

The feeder circuit 56 of the eleventh example constitutes an LC parallel resonance circuit using a floating capacitance between spiral conductor patterns as a capacitance component. The feeder circuit board 50 is a single-layer board made of a dielectric or a magnetic material.

In the electromagnetic-coupling module 1k of the eleventh example, the feeder circuit 56 is mainly magnetically coupled with the radiation plate 20. Therefore, similarly to each of the above-described examples, a high-frequency signal emitted from a reader/writer is received at the radiation plate 20, and the feeder circuit 56 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 56. Thereafter, a transmission signal is transmitted from the inductance element of the feeder circuit 56 to the radiation plate 20 via magnetic coupling. Then, the transmission signal is transmitted and transferred from the radiation plate 20 to the reader/writer.

Similarly to the first example, the positioning accuracy of the wireless IC chip 5 is satisfactory since the wireless IC chip 5 is provided on the small rigid feeder circuit board 50. The wireless IC chip 5 can be connected to the feeder circuit board 50 by using solder bumps.

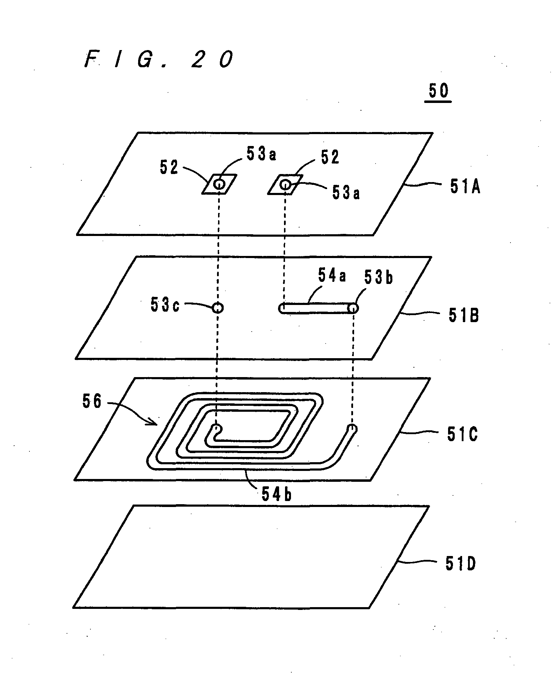

### (Twelfth Example of Electromagnetic-Coupling Module, see Figs. 19 and 20)

As shown in Fig. 19, an electromagnetic-coupling module 11 of a twelfth example includes a feeder circuit 56 defined by a coil-shaped electrode pattern contained in a feeder circuit board 50. As shown in Fig. 20, the feeder circuit board 50 is obtained by laminating, press-bonding and sintering ceramic sheets 51A to 51D made of a dielectric. The feeder circuit board 50 includes a sheet 51A on which connection electrodes 52 and viahole conductors 53a are formed; a sheet 51B on which a conductor pattern 54a and viahole conductors 53b and 53c are formed; a sheet 51C on which a conductor pattern 54b is formed; and a plain sheet 51D (one or more).

By stacking the above sheets 51A to 51D, the feeder circuit board 50, in which the feeder circuit 56 is defined by a resonance circuit formed of a spiral inductance element and a capacitance component formed by a floating capacitance between wires of the spiral conductors, is obtained. The connection electrodes 52 positioned at both ends of the feeder circuit 56 are connected to the wireless IC chip 5 via solder bumps 6. The operation and effect of the twelfth example are the same as those of the eleventh example.

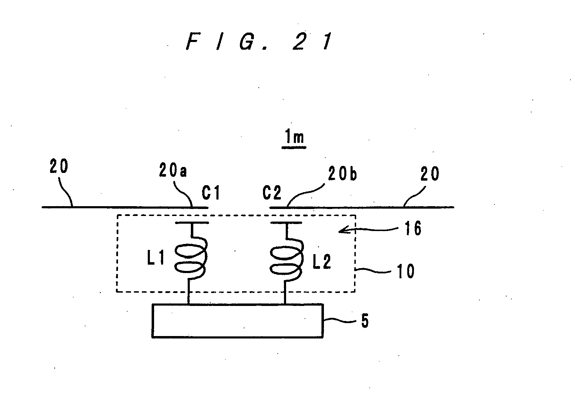

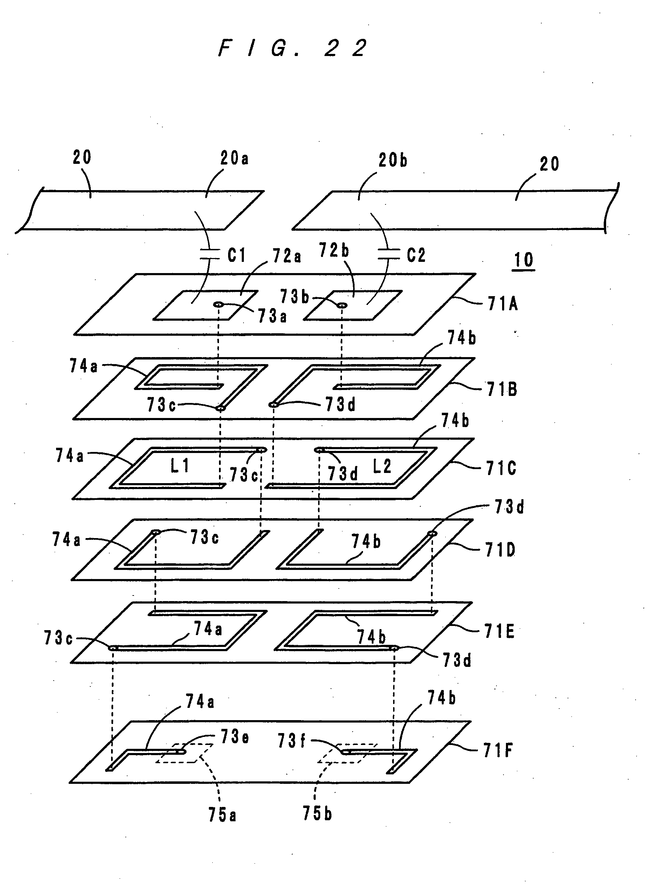

### (Thirteenth Example of Electromagnetic-Coupling Module, See Figs. 21 and 22)

As shown as an equivalent circuit in Fig. 21, in an electromagnetic-coupling module 1m of a thirteenth example, a feeder circuit board 10 is capacitively coupled with radiation plates 20. The feeder circuit board 10 contains a feeder circuit 16 formed of two LC series resonance circuits. Respective one ends of inductance elements L1 and L2 are connected to a wireless IC chip 5, and the other ends are connected to capacitor electrodes 72a and 72b (see Fig. 22) defining capacitance elements C1 and C2 provided on the surface of the board 10. End portions 20a and 20b of the radiation plate 20 function as the other capacitor electrodes constituting the capacitance elements C1 and C2.

More specifically, as shown in Fig. 22, the feeder circuit board 10 is obtained by laminating, press-bonding and sintering ceramic sheets 71A to 71F made of a dielectric. The feeder circuit substrate 10 includes a sheet 71A on which capacitor electrodes 72a and 72b and viahole conductors 73a and 73b are formed; sheets 71B to 71E on which conductor patterns 74a and 74b and viahole conductors 73c and 73d are formed; and a sheet 71F, on one surface of which conductor patterns 74a and 74b are formed and on the other surface of which connection electrodes 75a and 75b are formed, the conductor patterns 74a and 74b being connected to the connection electrodes 75a and 75b by viahole conductors 73e and 73f, respectively.

By stacking the above sheets 71A to 71F, the feeder circuit 16 is defined by twc LC series resonance circuits, in which the inductance elements L1 and L2 are connected in series with the capacitance elements C1 and C2. By bonding the feeder circuit board 10 to the radiation plates 20 by an adhesive agent, the capacitor electrodes 72a and 72b, which are planar electrode patterns disposed in parallel to the radiation plates 20, face the end portions 20a and 20b of the radiation plate 20 via the insulating adhesive layer, and the capacitance elements C1 and C2 are defined. By bonding the electrodes 75a and 75b to the wireless IC chip 5 via solder bumps, one end of each of the inductance elements L1 and L2 is connected to the wireless IC chip 5, and thereby, the wireless IC chip 5 and the feeder circuit substrate 10 are directly connected electrically to each other.

When the bonding agent contains, for example, dielectric powder, the bonding layer has properties as a dielectric, and accordingly, the capacitance of the capacitance elements C1 and C2 increases. In the thirteenth example, the capacitor electrodes 72a and 72b, that are second board-side electrode patterns, are formed on the reverse surface of the feeder circuit board 10. The capacitor electrodes 72a and 72b may be formed inside the feeder circuit board 10 (at a portion closer to the radiation plate 20). The capacitor electrodes 72a and 72b may also be provided in the internal layer of the board 10.

The operation and effect of the thirteenth example are basically the same as those of the first example. That is, in the electromagnetic-coupling module 1m, a high-frequency signal (for example, a UHF frequency band) emitted from a reader/writer (not shown) is received at the radiation plate 20, and the feeder circuit 16 (the LC series resonance circuit formed of an inductance element L1 and a capacitance element C1, and the LC series resonance circuit formed of an inductance element L2 and a capacitance element C2) that is capacitively coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 via capacitive coupling formed by the capacitance elements C1 and C2. Then, the transmission signal is transmitted and transferred from the radiation plate 20 to the reader/writer.

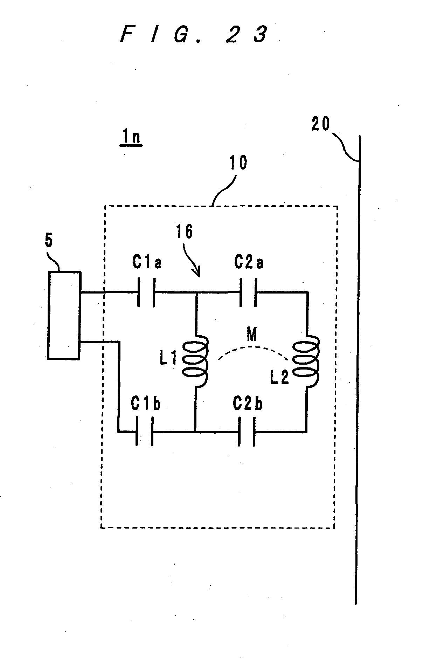

### (Fourteenth Example of Electromagnetic-Coupling Module, See Figs. 23 to 25)

As shown as an equivalent circuit in Fig. 23, in an electromagnetic-coupling module 1n of a fourteenth example, a feeder circuit 16 includes inductance elements L1 and L2 that are magnetically coupled with each other. The inductance element L1 is connected to a wireless IC chip 5 via capacitance elements C1a and C1b, and is connected in parallel with the inductance element L2 via capacitance elements C2a and C2b. In other words, the feeder circuit 16 is configured to include an LC series resonance circuit formed of the inductance element L1 and the capacitance elements C1a and C1b, and an LC series resonance circuit formed of the inductance element L2 and the capacitance elements C2a and C2b. The resonance circuits are coupled with each other by magnetic coupling indicated by M in Fig. 23. Both the inductance elements L1 and L2 are magnetically coupled with a radiation plate 20.

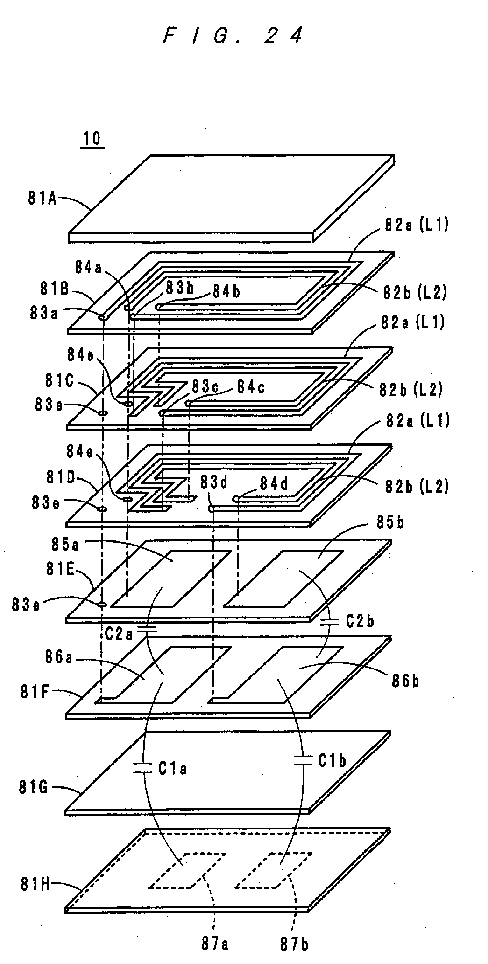

More specifically, as shown in Fig. 24, a feeder circuit board 10 is obtained by laminating, press-bonding and sintering ceramic sheets 81A to 81H made of a dielectric. The feeder circuit board 10 includes a plain sheet 81A; a plain sheet 81B on which conductor patterns 82a and 82b and viahole conductors 83a 83b, 84a, and 84b are formed; a sheet 81C on which conductor patterns 82a and 82b and viahole conductors 83c, 84c, 83e, and 84e are formed; a sheet 81D on which conductor patterns 82a and 82b and viahole conductors 83d, 84d, 83e, and 84e are formed; a sheet 81E on which capacitor electrodes 85a and 85b and a viahole conductor 83e are formed; a sheet 81F on which capacitor electrodes 86a and 86b are formed; a plain sheet 81G; and a sheet 81H on which capacitor electrodes 87a and 87b are formed on its reverse surface.

By stacking the above sheets 81A to 81H, the conductor patterns 82a are connected via the viahole conductors 83b and 83c, thereby forming the inductance element L1, and the conductor patterns 82b are connected via the viahole conductors 84b and 84c, thereby forming the inductance element L2. The capacitor electrodes 86a and 87a form the capacitance element C1a, and the capacitor electrode 86a is connected to one end of the inductance element L1 via the viahole conductor 83e. The capacitor electrodes 86b and 87b form the capacitance element C1b, and the capacitor electrode 8 6b is connected to the other end of the inductance element L1 via the viahole conductor 83d. The capacitor electrodes 85a and 86a form the capacitance element C2a, and the capacitor electrode 85a is connected to one end of the inductance element L2 via the viahole conductor 84e. The capacitor electrodes 85b and 86b form the capacitance element C2b, and the capacitor electrode 85b is connected to the other end of the inductance element L2 via the viahole conductor 84d.

The operation and effect of the fourteenth example are basically the same as those of the first example. That is, in the electromagnetic-coupling module 1n, a high-frequency signal (for example, a UHF frequency band) emitted from a reader/writer (not shown) is received at the radiation plate 20, and the feeder circuit 16 (the LC series resonance circuit formed of an inductance element L1 and capacitance elements C1a and C1b, and the LC series resonance circuit formed of an inductance element L2 and a capacitance elements C2a and C2b) that is mainly magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted from the inductance elements L1 and L2 of the feeder circuit 16 to the radiation plate 20 via magnetic coupling. Then, the transmission signal is transmitted and transferred from the radiation plate 20 to the reader/writer.

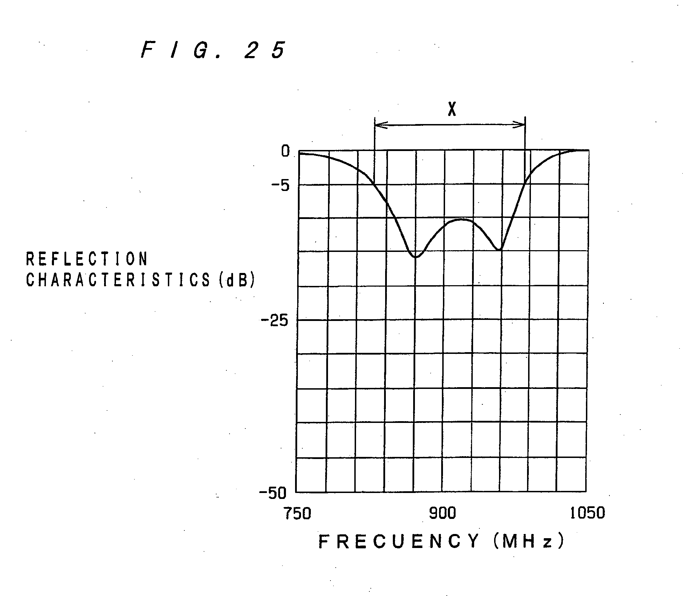

In particular, in the fourteenth example, regarding the reflection characteristics, the frequency band is wide as indicated as a bandwidth X in Fig. 25. This results from the fact that the feeder circuit 16 is configured by a plurality of LC resonance circuits including inductance elements L1 and L2 that are magnetically coupled with each other at a high degree of coupling. Furthermore, since the capacitance elements C1a and C1b are disposed at a stage subsequent to the wireless IC chip 5, surge resistance is improved.

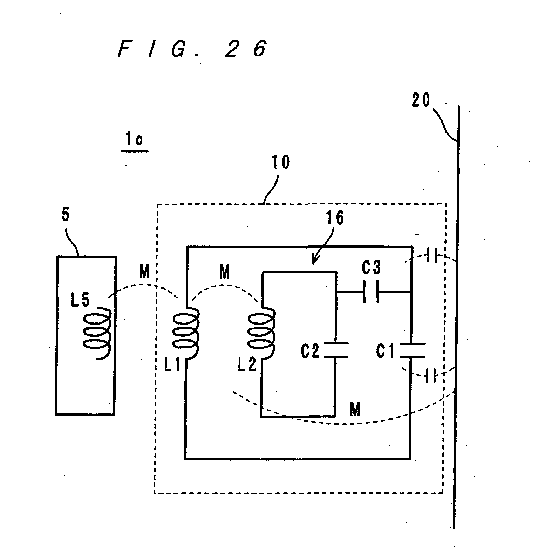

### (Fifteenth Example of Electromagnetic-Coupling Module, See Figs. 26 to 28)

As shown as an equivalent circuit in Fig. 26, in an electromagnetic-coupling module 1o of a fifteenth example, a feeder circuit 16 includes inductance elements L1 and L2 that are magnetically coupled with each other at a high degree of coupling. The inductance element L1 is magnetically coupled with an inductance element L5 provided in a wireless IC chip 5. The inductance element L2 and a capacitance element C2 form an LC series resonance circuit. Furthermore, a capacitance element C1 is capacitively coupled with a radiation plate 20, and another capacitance element C3 is disposed between the capacitance elements C1 and C2.

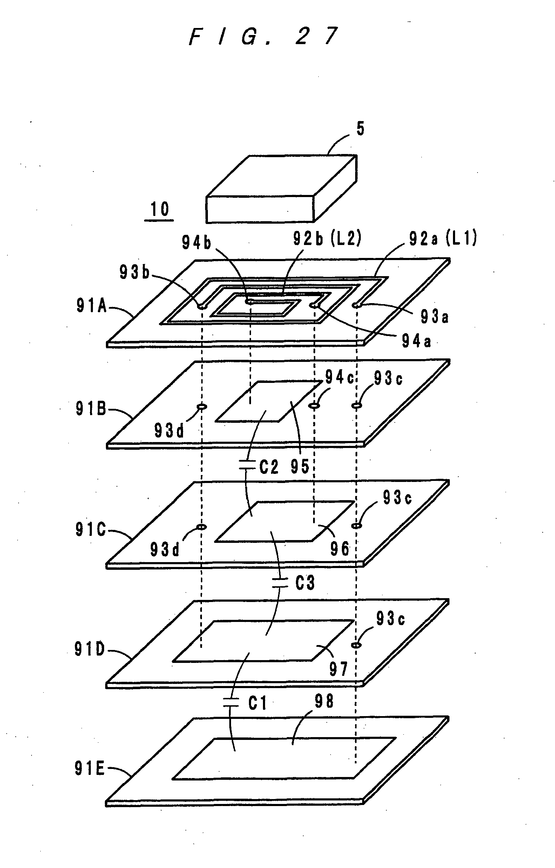

More specifically, as shown in Fig. 27, a feeder circuit board 10 is obtained by laminating, press-bonding and sintering ceramic sheets 91A to 91E. The feeder circuit board 10 includes a sheet 91A on which conductor patterns 92a and 92b and viahole conductors 93a, 93b, 94a, and 94b are formed; a sheet 91B on which a capacitor electrode 95 and viahole conductors 93c, 93d, and 94c are formed; a sheet 91C on which a capacitor electrode 96 and viahole conductors 93c and 93d are formed; a sheet 91D on which a capacitor electrode 97 and a viahole conductor 93c are formed; a sheet 91E on which a capacitor electrode 98 is formed.

By stacking these sheets 91A to 91E, the conductor pattern 92a forms an inductance element L1, and the conductor pattern 92b forms an inductance element L2. The capacitor electrodes 97 and 98 form the capacitance element C1. One end of the inductance element L1 is connected to the capacitor electrode 98 via the viahole conductors 93a and 93c, and the other end thereof is connected to the capacitor electrode 97 via the viahole conductors 93b and 93d. The capacitor electrodes 95 and 96 form the capacitance element C2. One end of the inductance element L2 is connected to the capacitor electrode 96 via the viahole conductors 94a and 94c, and the other end thereof is connected to the capacitor electrode 95 via the viahole conductor 94b. Furthermore, the capacitor electrodes 96 and 97 form the capacitance element C3.

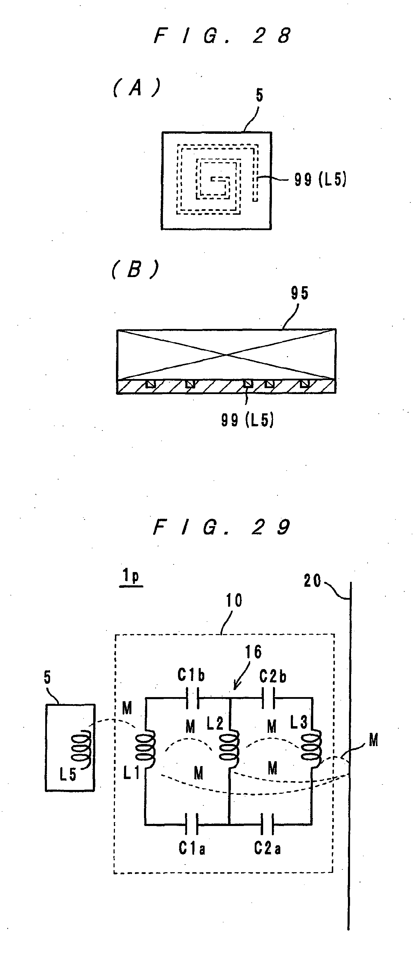

As shown in Fig. 28, a coil-shaped electrode pattern 99 is provided on the reverse surface of the wireless IC chip 5 as a chip-side electrode pattern, and the coil-shaped electrode pattern 99 forms an inductance element L5. The obverse surface of the coil-shaped electrode pattern 99 is provided with a protective film made of resin. As a result, the inductance elements L1 and L2 defined by the coil-shaped electrode patterns, which are board-side electrode patterns, are magnetically coupled with the coil-shaped electrode pattern 99.

The operation and effect of the fifteenth example are basically the same as those of the first example. That is, in the electromagnetic-coupling module 10, a high-frequency signal (for example, a UHF frequency band) emitted from a reader/writer (not shown) is received at the radiation plate 20, and the feeder circuit 16 (the LC series resonance circuit formed of an inductance element L2 and a capacitance element C2) that is capacitively and magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 via capacitive coupling and magnetic coupling, and is transmitted and transferred from the radiation plate 20 to the reader/writer. The feeder circuit 16 and the wireless IC chip 5 are magnetically coupled by the inductance elements L1 and L5, and power and a transmission/receiving signal are transmitted.

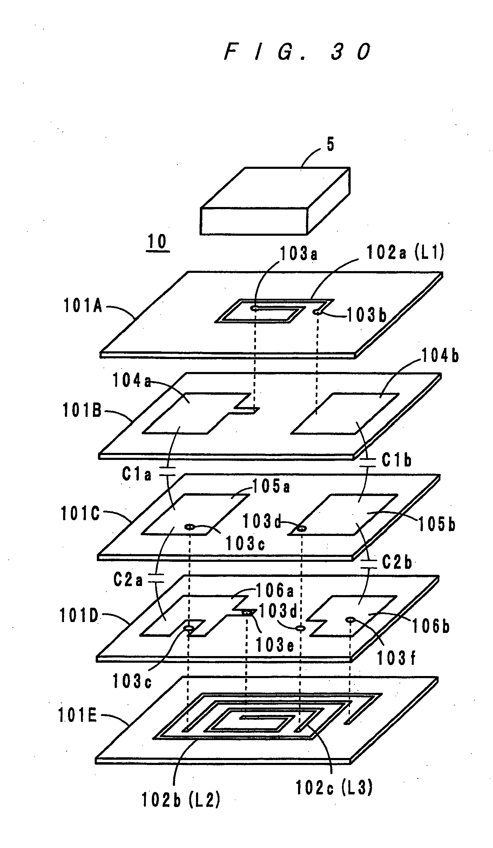

### (Sixteenth Example of Electromagnetic-Coupling Module, See Figs. 29 and 30)

As shown as an equivalent circuit in Fig. 29, in an electromagnetic-coupling module 1p of a sixteenth example, a feeder circuit 16 includes inductance elements L1, L2, and L3 that are magnetically coupled with one another at a high degree of coupling. The inductance element L1 is magnetically coupled with an inductance element L5 provided in a wireless IC chip 5. The inductance element L2 and capacitance elements C1a and C1b form an LC series resonance circuit, and the inductance element L3 and capacitance elements C2a and C2b form an LC series resonance circuit. The inductance elements L1, L2, and L3 are each magnetically coupled with a radiation plate 20.

More specifically, as shown in Fig. 30, a feeder circuit board 10 is obtained by laminating, press-bonding and sintering ceramic sheets 101A to 101E made of a dielectric. The feeder circuit board 10 includes a sheet 101A on which a conductor pattern 102a and viahole conductors 103a and 103b are formed; a sheet 101B on which capacitor electrodes 104a and 104b are formed; a sheet 101C on which capacitor electrodes 105a and 105b and viahole conductors 103c and 103d are formed; a sheet 101D on which capacitor electrodes 106a and 106b and viahole conductors 103c, 103d, 103e, and 103f are formed; and a sheet 101E on which conductor patterns 102b and 102c are formed. That is, spaces are provided among the electrodes 104a, 105a and 106a defining the capacitance elements C1a and C2a and among the electrodes 104b, 105b and 106b defining the capacitance elements C1b and C2b so that a magnetic flux generated by the inductance element L1 reaches the inductance elements L2 and L3 and further reaches the radiation plate 20.

By stacking these sheets 101A to 101E, the conductor pattern 102a forms the inductance element L1. The conductor pattern 102b forms the inductance element L2. The conductor pattern 102c forms the inductance element L3. The capacitor electrodes 104a and 105a form the capacitance element C1a. The capacitor electrodes 104b and 105b form the capacitance element C1b. Furthermore, the capacitor electrodes 105a and 106a form the capacitance element C2a. The capacitor electrodes 105b and 106b form the capacitance element C2b.

One end of the inductance element L1 is connected to the capacitor electrode 104a via the viahole conductor 103a, and the other end thereof is connected to the capacitor electrode 104b via the viahole conductor 103b. One end of the inductance element L2 is connected to the capacitor electrode 105a via the viahole conductor 103c, and the other end thereof is connected to the capacitor electrode 106b via the viahole conductor 103f. One end of the inductance element L3 is connected to the capacitor electrode 106a via the viahole conductor 103e, and the other end thereof is connected to the capacitor electrode 105b via the viahole conductor 103d.

As shown in Fig. 28, on the reverse surface of the wireless IC chip 5, a coil-shaped electrode pattern 99 is provided as a chip-side electrode pattern, and the coil-shaped electrode pattern 99 forms the inductance element L5. On the obverse surface of the coil-shaped electrode pattern 99, a protective film made of resin is provided. As a result, the inductance element L1 defined by the coil-shaped electrode pattern, that is a board-side electrode pattern, and the coil-shaped electrode pattern 99 are magnetically coupled with each other.

The operation and effect of the sixteenth example are basically the same as those of the fourteenth example. That is, in the electromagnetic-coupling module 1p, a high-frequency signal (for example, a UHF frequency band) emitted from a reader/writer (not shown) is received at the radiation plate 20, and the feeder circuit 16 (the LC series resonance circuit formed of an inductance element L2 and capacitance elements C1a and C1b, and the LC series resonance circuit formed of an inductance element L3 and capacitance elements C2a and C2b) that is magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 from the inductance elements L1, L2, and L3 of the feeder circuit 16 via magnetic coupling, and is transmitted and transferred from the radiation plate 20 to the reader/writer. The feeder circuit 16 and the wireless IC chip 5 are magnetically coupled with the inductance elements L1 and L5, and power and a transmission/receiving signal are transmitted.

In particular, in the sixteenth example, since the feeder circuit 16 is configured by a plurality of LC resonance circuits including the inductance elements L2 and L3 that are magnetically coupled with each other, the frequency band is wide as in the case of the fourteenth example.

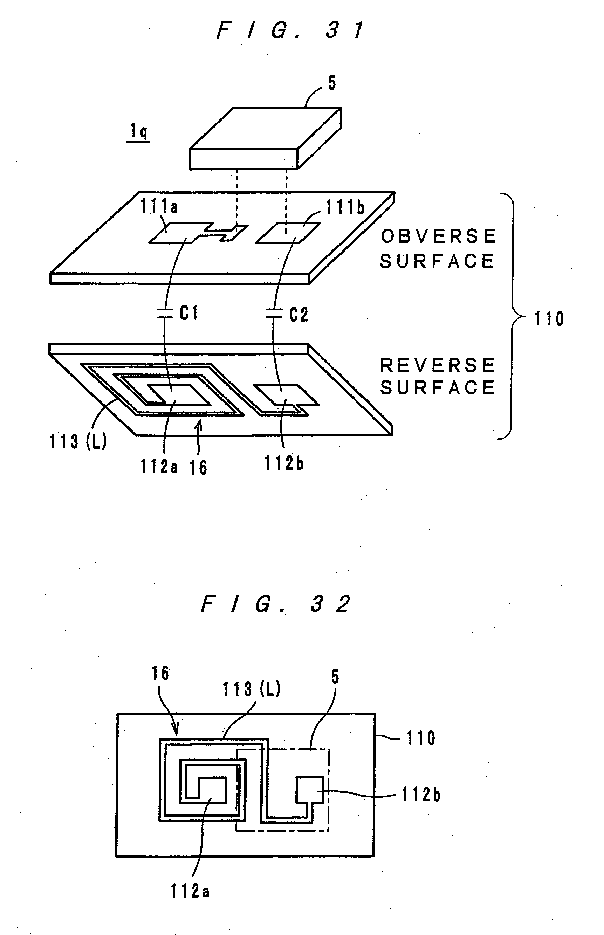

### (Seventeenth Example of Electromagnetic-Coupling Module, See Figs. 31 to 34)

In an electromagnetic-coupling module 1q of a seventeenth example, a feeder circuit board 110 is configured by a single-layer board, and the equivalent circuit thereof is the same as that of Fig. 3. That is, the feeder circuit 16 is defined as an LC series resonance circuit in which capacitance elements C1 and C2 are connected to both ends of an inductance element L. The feeder circuit board 110 is a ceramic board made of a dielectric. As shown in Fig. 31, on the obverse surface thereof, capacitor electrodes 111a and 111b are formed, and on the reverse surface thereof, capacitor electrodes 112a and 112b and a conductor pattern 113 are formed. The capacitor electrodes 111a and 112a form a capacitance element C1, and the capacitor electrodes 111b and 112b form a capacitance element C2.

The operation and effect of the seventeenth example are basically the same as those of the first example. That is, in the electromagnetic-coupling module 1q, a high-frequency signal (for example, a UHF frequency band) emitted from a reader/writer (not shown) is received at the radiation plate 20, and the feeder circuit 16 (the LC series resonance circuit formed of an inductance element L and capacitance elements C1 and C2) that is magnetically coupled with the radiation plate 20 is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate 20 from the inductance element L of the feeder circuit 16 via magnetic coupling, and is transmitted and transferred from the radiation plate 20 to the reader/writer.

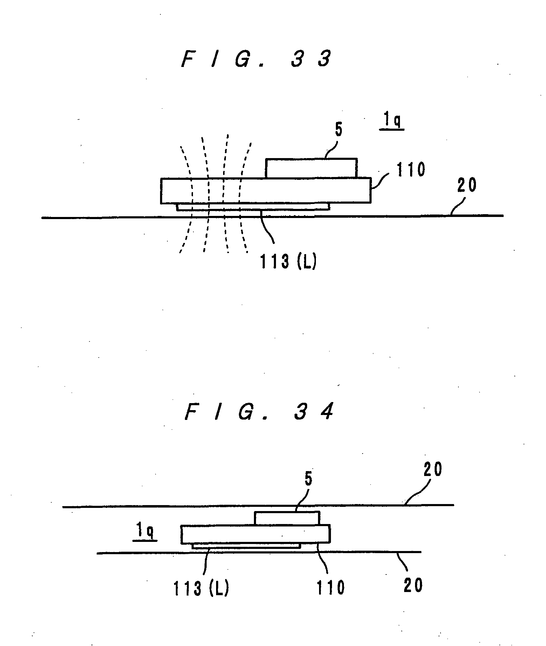

In particular, in the seventeenth example, as shown in Figs. 32 and 33, the inductance element L is disposed so as to overlap the wireless IC chip 5 only partially in plan view. As a result, most of the magnetic flux generated in the inductance element L is not shielded by the wireless IC chip 5, and the rise of the magnetic flux becomes satisfactory.

In the seventeenth example, as shown in Fig. 34, the feeder circuit board 110 with the wireless IC chip 5 mounted thereon may be sandwiched between the radiation plates 20 and 20. The magnetic coupling efficiency of the feeder circuit 16 and the radiation plates 20 and 20 is improved, and the gain is improved.

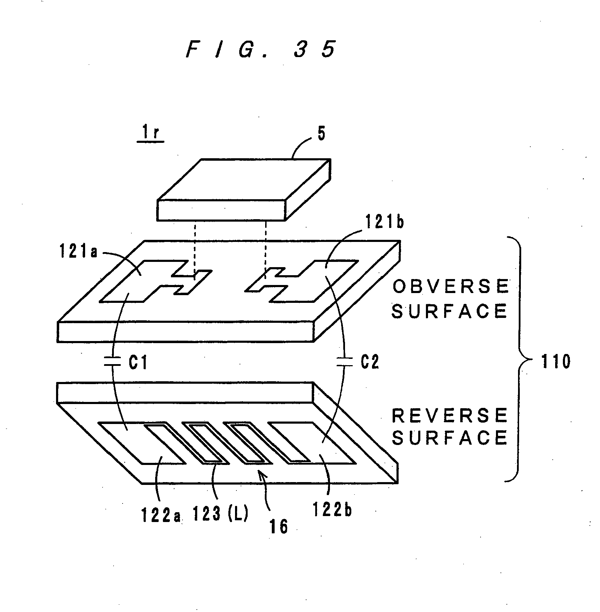

### (Eighteenth Example of Electromagnetic-Coupling Module, See Fig. 35)

In an electromagnetic-coupling module 1r of an eighteenth example, an inductance element L is formed by a meandering line electrode pattern, and the equivalent circuit thereof is the same as that of Fig. 3. That is, a feeder circuit 16 is defined as an LC series resonance circuit in which capacitance elements C1 and C2 are connected to both ends of an inductance element L. The feeder circuit board 110 is a ceramic single-layer board made of a dielectric. As shown in Fig. 35, on the obverse surface thereof, capacitor electrodes 121a and 121b are formed, and on the reverse surface thereof, capacitor electrodes 122a and 122b and a meandering conductor pattern 123 are formed. The capacitor electrodes 121a and 122a form a capacitance element C1, and the capacitor electrodes 121b and 122b form a capacitance element C2.

The operation and effect of the eighteenth example are basically the same as those of the first example. That is, in the electromagnetic-coupling module 1r, a high-frequency signal (for example, a UHF frequency band) emitted from a reader/writer (not shown) is received at a radiation plate opposing the conductor pattern 123, and the feeder circuit 16 (the LC series resonance circuit formed of an inductance element L and capacitance elements C1 and C2) that is magnetically coupled with the radiation plate is caused to resonate. Thereby, only a received signal at a predetermined frequency band is supplied to the wireless IC chip 5. On the other hand, predetermined energy is extracted from the received signal, and by using the energy as a driving source, the information memorized in the wireless IC chip 5 is matched with a predetermined frequency at the feeder circuit 16. Thereafter, a transmission signal is transmitted to the radiation plate from the inductance element L of the feeder circuit 16 via magnetic coupling, and is transmitted and transferred from the radiation plate 20 to the reader/writer.

In particular, in the eighteenth example, since the inductance element L is defined by the meandering conductor pattern 123, and it is effective for transmitting and receiving high-frequency signals.

In the seventeenth example and in the eighteenth example, it is also possible to construct the feeder circuit board 110 by using a multilayer board.

Next, examples and an embodiment of various articles to which the above-described electromagnetic-coupling modules are attached will be described.

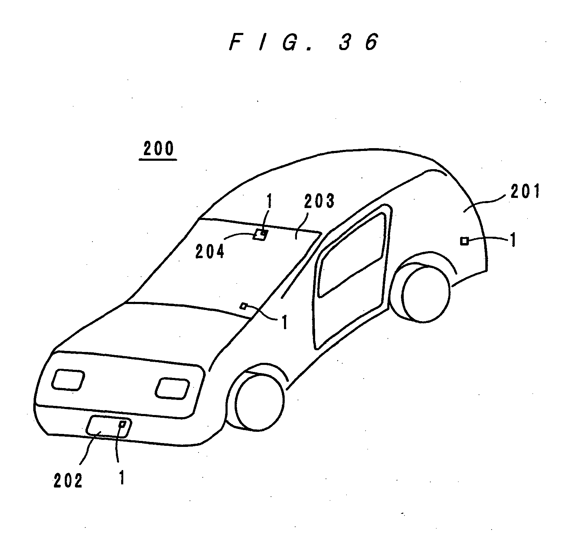

### (First example, See Fig. 36)

As shown in Fig. 36, in a first example, the module 1 is applied to an automobile 200, and a car body 201, including a steel plate part, of the automobile 200 is used as a radiation plate. The electromagnetic-coupling module 1 is bonded to the steel plate part of the car body 201, and the feeder circuit is electromagnetically coupled with the steel plate part (radiation plate). Asset management of the automobile 200 can be performed on the basis of automobile inspection information, automobile registration information, user information, and the like stored in a wireless IC chip provided in the electromagnetic-coupling module 1. The electromagnetic-coupling module 1 may be bonded (contained) to a number-plate 202 so that the number-plate 202 functions as a radiation plate. Alternatively, a metal object, such as a defogger (a defogging conductor pattern) may be used as a radiation plate.

When the electromagnetic-coupling module 1 is bonded to the number-plate 202, information, such as the registration number, the registration date, and the automobile inspection information of the automobile 200, is stored in the wireless IC chip, and the information is transmitted to a roadside unit having a reader. In this case, the number-plate 202 functions as an electronic number-plate (smart plate). The electromagnetic-coupling module 1 employs a passive system, that is, a system in which a battery is not contained and an electrical current is generated by using an electromagnetic wave input from outside as a driving source. Accordingly, problems, such as a battery run-down, do not occur. Also, by mounting an RFID reader on an investigating vehicle, it is possible to easily find a car having a forged number-plate, a stolen car, or the like even in an area in which a roadside unit is not disposed.

The first example is not limited to be applied to the automobile 200 and may be applied to other vehicles, such as an airplane, a ship, a bus, construction equipment (e.g. a crane or a forklift), a motorcycle and a bicycle, and asset management thereof can be performed.

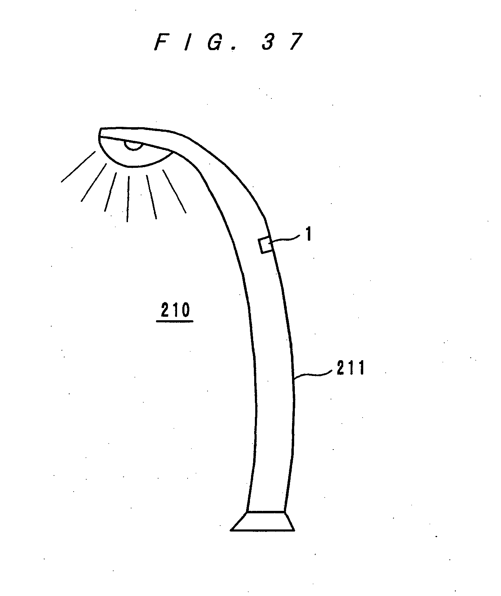

### (Second example, See Fig. 37)

As shown in Fig. 37, a second example is applied to a lamp 210 disposed in an expressway. The electromagnetic-coupling module 1 is bonded to a metal pole part 211 of the lamp 210, and the pole part 211 is used as a radiation plate. The feeder circuit of the electromagnetic-coupling module 1 is electromagnetically coupled with the pole part 211. Asset management can be performed on the basis of the installation date, equipment information, and used materials of the lamp 210, and the like, which are stored in the wireless IC chip. In addition to the lamp 210, it is also possible to perform asset management of equipment installed in a public park, a public building, and the like.

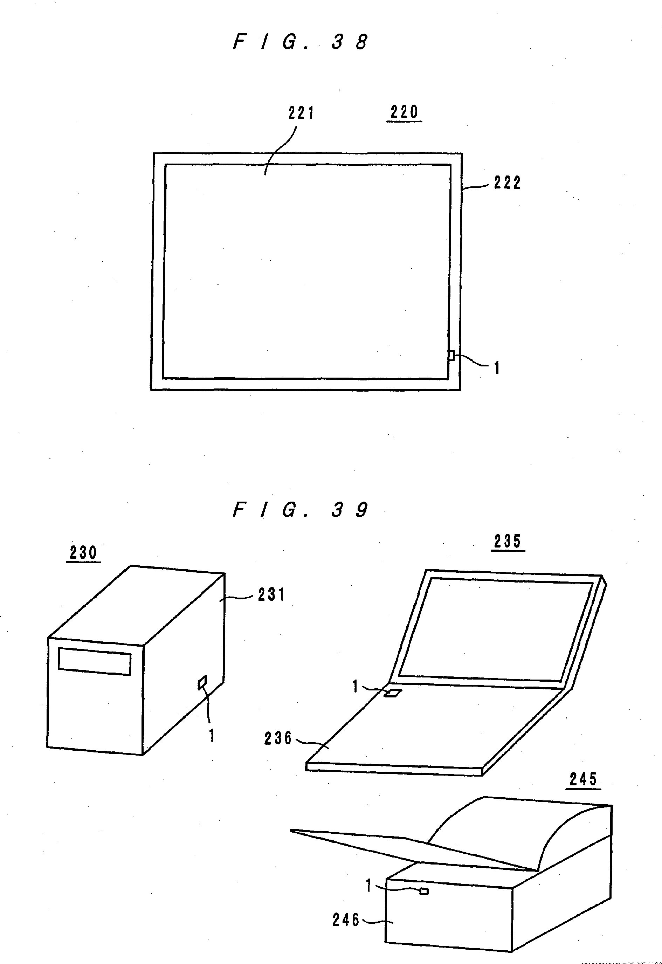

### (Third example, See Fig. 38)

As shown in Fig. 38, in a third example, the module is applied to electronic paper 220 formed of a display screen 221 and a frame part 222, and the metal frame part 222 of the electronic paper 220 is used as a radiation plate. The feeder circuit of the electromagnetic-coupling module 1 is electromagnetically coupled with the frame part 222. It is possible to perform asset management on the basis of the purchase date, the purchase price, the purchaser, and the like of the electronic paper 220, which are stored in the wireless IC chip.

### (Fourth example, See Fig. 39)

In a fourth example, as shown in Fig. 39, metal housing part 231 of a body 230 of a desk-top computer or a housing part 236 of a notebook computer 235 is used as a radiation plate. The feeder circuit of the electromagnetic-coupling module 1 is electromagnetically coupled with the housing part 231 or 236. A housing part 246 of a printer 245 may be used as a radiation plate. It is possible to perform asset management based on the purchase date, the purchase price, and the like of the body 230, the notebook computer 235 or the printer 245 stored in the wireless IC chip.

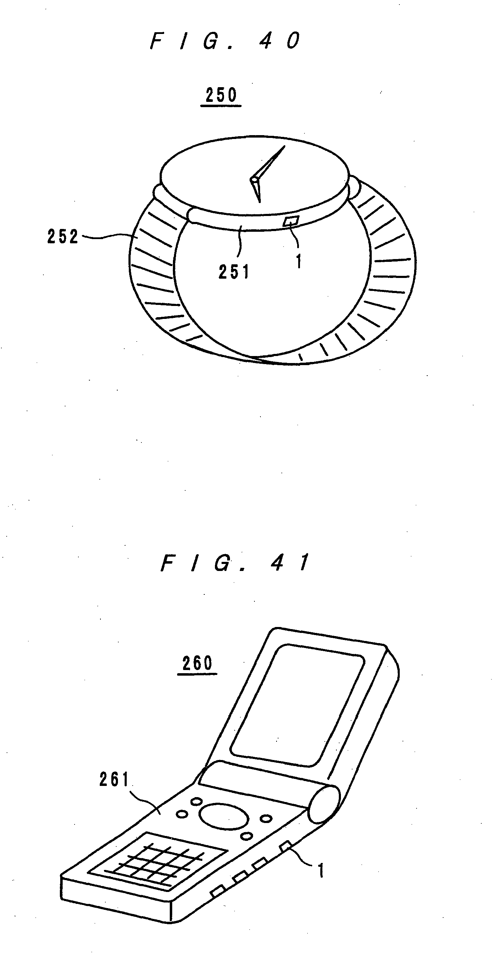

### (Fifth example, See Fig. 40)

In a fifth example, as shown in Fig. 40, a metal case 251 or a metal strap 252 of a wristwatch 250 is used as a radiation plate. The feeder circuit of the electromagnetic-coupling module 1 is electromagnetically coupled with the case 251 or the strap 252. It is possible to perform asset management on the basis of the purchase date, the purchase price, and the like of the wristwatch 250 stored in the wireless IC chip.

### (Embodiment, See Fig. 41)

In an embodiment, as shown in Fig. 41, a metal housing part 261 (a conductive paint applied onto the housing if the housing part is non-metal) of a mobile phone 260 is used as a radiation plate. The feeder circuit of the electromagnetic-coupling module 1 is electromagnetically coupled with the housing part 261 or the conductive paint. It is possible to perform asset management of the purchase date, the purchase price, and the like of the mobile phone 260. Such asset management can be applied not only to the mobile phone 260 but also to other mobile devices, such as a PDA, a digital camera, a portable game machine, and a communication device.

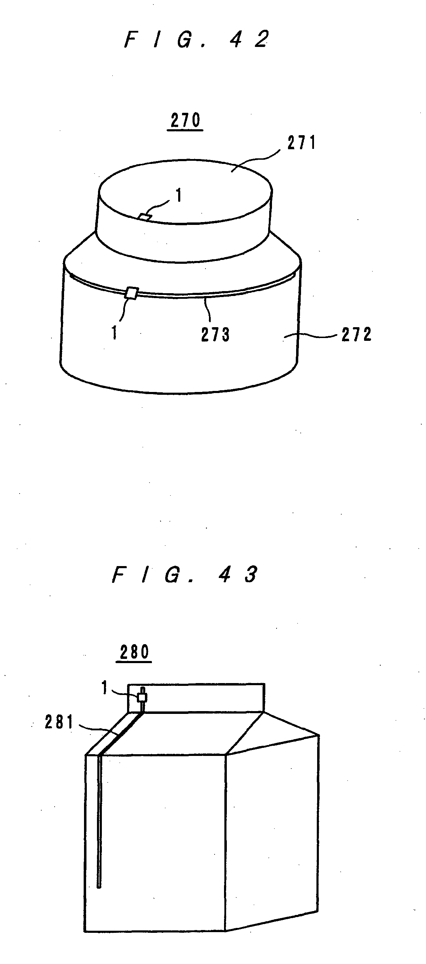

### (Sixth example, See Fig. 42)

In a sixth example, as shown in Fig. 42, an aluminum lid 271 of a jar 270 for preserving food is used as a radiation plate. The feeder circuit of the electromagnetic-coupling module 1 is electromagnetically coupled with the lid 271, and the electromagnetic-coupling module 1 communicates with a reader/writer of an RFID system. In the sixth example, it is possible to perform asset management of the manufacturing date, the kind of food, and the like. Furthermore, by storing distribution history of the food in the wireless IC chip and by timely updating the history, inventory control becomes easy.

If the lid 271 is made of resin and cannot be used as a radiation plate, a radiation plate 273 is printed on a label 272 of the jar 270 using a conductive paint as a part of the design of the label 272, and the electromagnetic-coupling module 1 is bonded thereto.

### (Seventh example, See Fig. 43)

In a seventh example, as shown in Fig. 43, a radiation plate 281 is printed on a carton 280 of milk or juice using a conductive paint as a part of the design, and the electromagnetic-coupling module 1 is bonded thereto. The usage of the seventh example is the same as that of the sixth example. A can of canned meat or other food may be used as a radiation plate, and a conductive paint printed on a wrapping of potato chips may be used as a radiation plate. That is, the seventh example can be used for wrapped food in general.

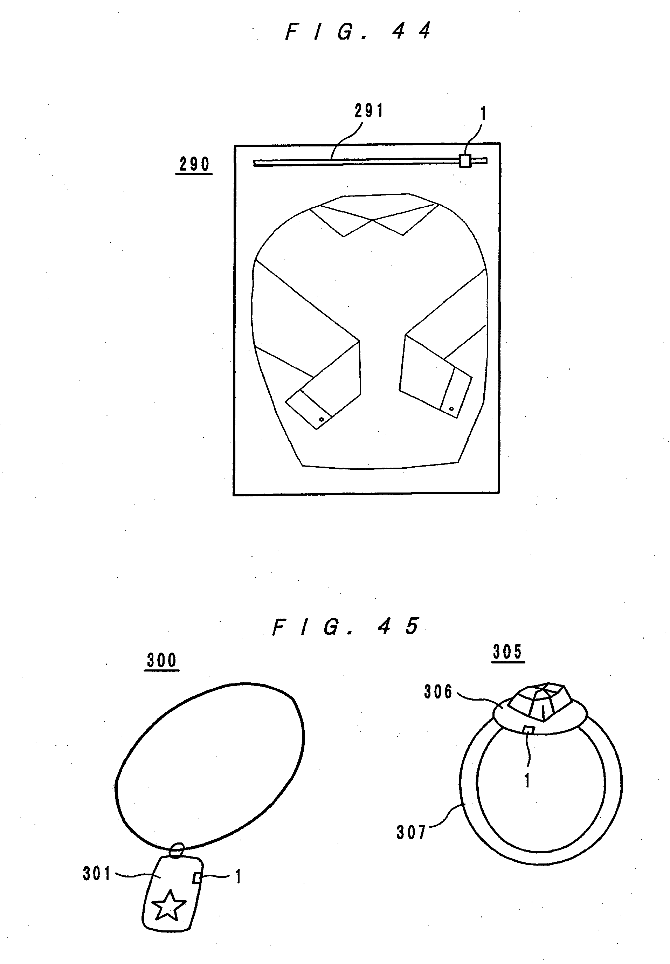

### (Eighth example, See Fig. 44)

In an eighth, as shown in Fig. 44, a radiation plate 291 is printed on a wrapping bag 290 for clothes using a conductive paint as a part of the design of the wrapping bag 290, and the electromagnetic-coupling module 1 is bonded thereto. The usage of the eighth example is the same as that of the sixth example. The article contained in the wrapping bag 290 is not limited to clothes and may be stationeries, daily goods, and the like.

### (Ninth example, See Fig. 45)

In a ninth example, as shown in Fig. 45, a metal charm 301 of a pendant 300, and a metal setting 306 or a metal band 307 of a ring 305 are used as a radiation plate. The feeder circuit of the electromagnetic-coupling module 1 is electromagnetically coupled with the charm 301 or the setting 306, and the electromagnetic-coupling module 1 communicates with a reader/writer of an RFID system. Also, in the ninth example, it is possible to perform asset management of the purchase date, the purchase price, and the like. Furthermore, by storing distribution history and the like in the wireless IC chip and timely updating the history, inventory control becomes easy.

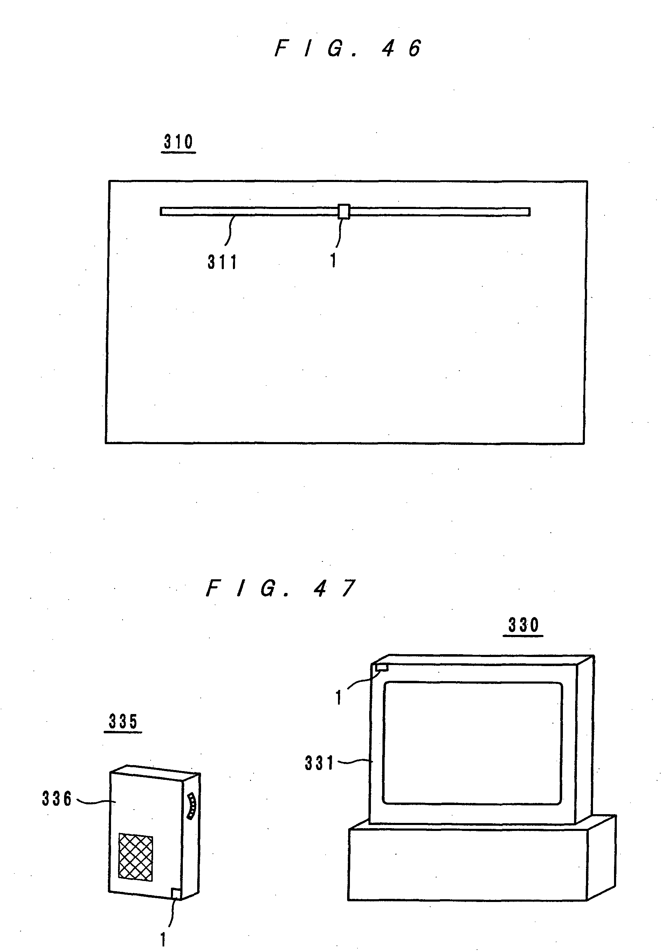

### (Tenth example, See Fig. 46)

In a tenth example, as shown in Fig. 46, a radiation plate 311 is printed on a security 310 using a conductive paint as a part of the design of the security 310, and the electromagnetic-coupling module 1 is bonded thereto. The tenth example can be used for asset management on the basis of value information stored in the wireless IC chip as an RFID system and can be used for the determination of authenticity of the security 310.

The tenth example can be applied not only to the security 310 but also to other paper products, such as paper money, an important document, an invoice, an envelope, a receipt form, a freight label, or a book. A document may be formed as a double-sheet laminate structure, and the radiation plate 311 and the electromagnetic-coupling module 1 may be inserted in the laminate structure. Alternatively, the radiation plate 311 and the electromagnetic-coupling module 1 may be provided inside an envelope, a book, or the like.

### (Eleventh example, See Fig. 47)

In an eleventh example, as shown in Fig. 47, a metal housing part 331 or 336 (a conductive paint may be applied onto the housing if the housing part is non-metal) of a television 330 or a radio 335 is used as a radiation plate. The feeder circuit of the electromagnetic-coupling module 1 is electromagnetically coupled with the housing part 331 or 336 or the conductive paint. It is possible to perform asset management by using an RFID system of the television 330 and the radio 335. The twelfth embodiment can also be applied to other AV home appliances as well as a television and a radio.

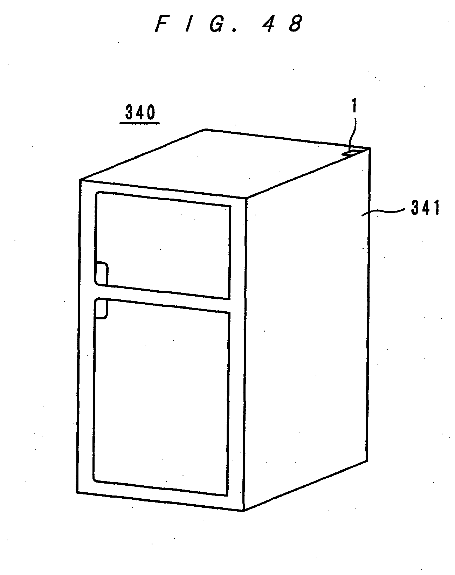

### (Twelfth example, See Fig. 48)

In a twelfth example, as shown in Fig. 48, a metal housing part 341 of a refrigerator 340 is used as a radiation plate. The feeder circuit of the electromagnetic-coupling module 1 is electromagnetically coupled with the housing part 341, and asset management of the refrigerator 340 is possible. The twelfth example can also be applied to large household appliances as well as the refrigerator 340.

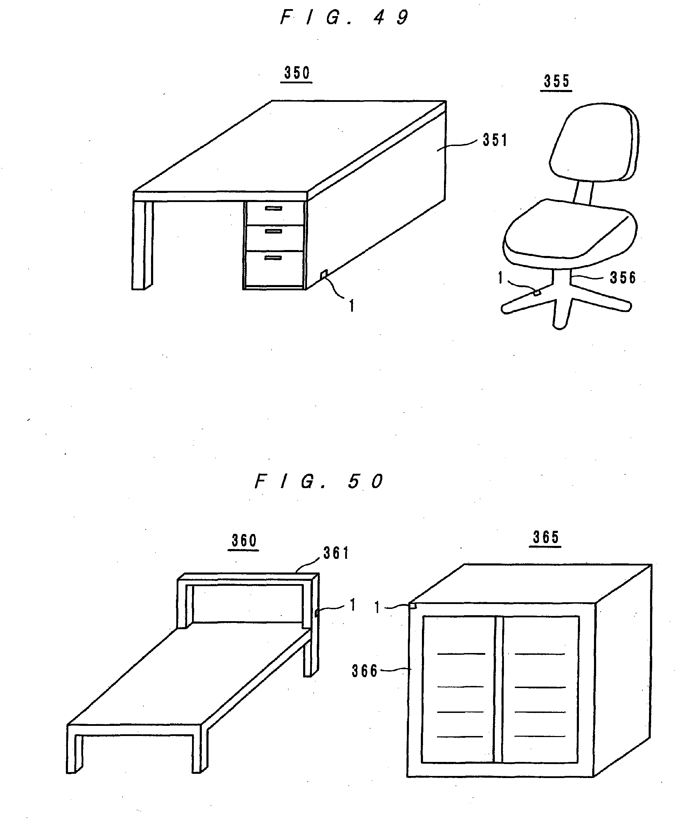

### (Thirdteeth example, See Fig. 49)

In a thirdteenth example, as shown in Fig. 49, a metal housing part 351 of a desk 350 or a metal leg part 356 of a chair 355 is used as a radiation plate. The feeder circuit of the electromagnetic-coupling module 1 is electromagnetically coupled with the housing part 351 or the leg part 356, and the electromagnetic-coupling module 1 communicates with a reader/writer of an RFID system. In the thirdteenth example, the electromagnetic-coupling module 1 is mainly used for management of fixed asset, such as for prevention of robbery. Of course, if distribution history and the like are stored in the wireless IC chip and are timely updated, the electromagnetic- coupling module 1 can also be used for inventory control at the distribution stage. The thirdteenth example can be widely applied to various kinds of office furniture in addition to the desk 350 and the chair 355.

### (Fourteenth example, See Fig. 50)

In a fourteenth example, as shown in Fig. 50, a metal frame 361 of a bed 360 or a housing part 366 of a cabinet 365 are used as a radiation plate. The feeder circuit of the electromagnetic-coupling module 1 is electromagnetically coupled with the frame 361 or the housing part 366, and the electromagnetic-coupling module 1 communicates with a reader/writer of an RFID system. The usage of the fifteenth embodiment is the same as that of the thirdteenth example. The fourteenth example can be widely applied to various kinds of household furniture, fixtures of a hotel, and the like as well as the bed 360 and the cabinet 365.

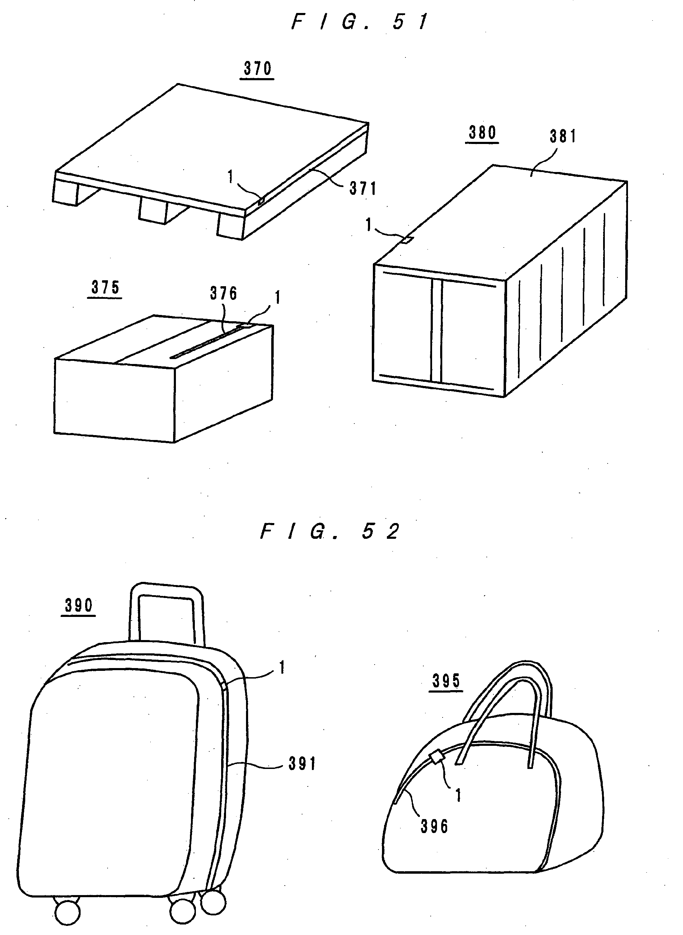

### (Fifteenth example, See Fig. 51)

In a fifteenth example, as shown in Fig. 51, a metal plate part 371 (a conductive paint may be applied to the plate part if the plate part is non-metal) of a palette 370, a conductive paint 376 applied to a cardboard box 375 or a metal housing part 381 of a freight container 380 is used as a radiation plate. The feeder circuit of the electromagnetic-coupling module 1 is electromagnetically coupled with the metal plate part 371, the conductive paint 376 or the housing part 381, and the electromagnetic-coupling module 1 communicates with a reader/writer of an RFID system. The electromagnetic-coupling module 1 is used for management of fixed asset and distribution management of articles.

### (Sixteenth example, See Fig. 52)

In a sixteenth example, as shown in Fig. 52, the electromagnetic-coupling module 1 is bonded to a metal fastener part 391 of a suitcase 390 or to a radiation plate 396 printed on a surface of a bag 395 by using a conductive paint as a part of the design. The feeder circuit of the electromagnetic-coupling module 1 is electromagnetically coupled with the fastener part 391 or the radiation plate 396, and the electromagnetic-coupling module 1 communicates with a reader/writer of an RFID system. The sixteenth example can be applied not only to asset management of the suitcase 390 and the bag 395 but also to distribution management in an airport or the like.

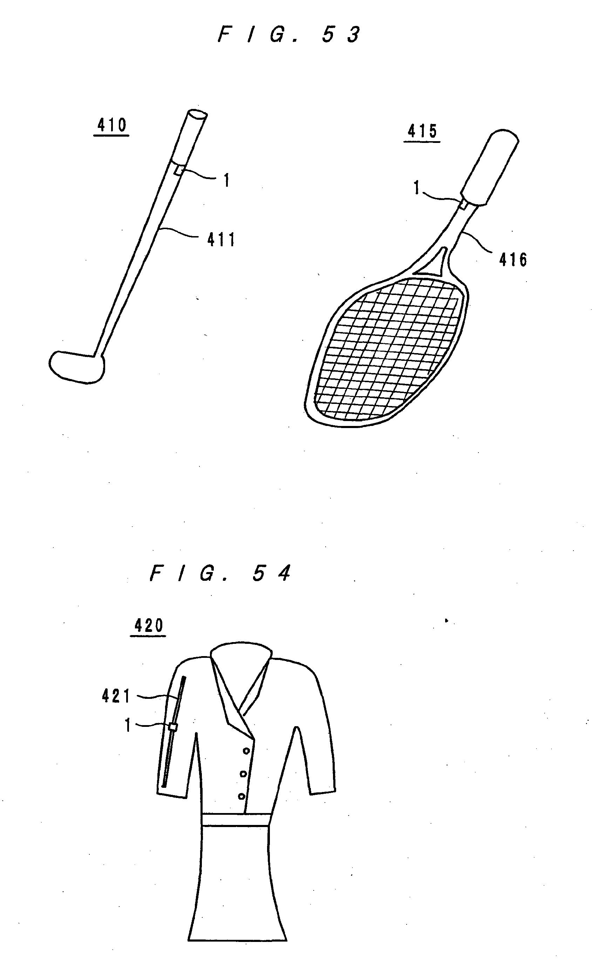

### (Seventeenth example, See Fig. 53)

In a seventeenth example, as shown in Fig. 53, a carbon shaft 411 of a golf club 410 or a carbon shaft 416 of a tennis racket 415 is used as a radiation plate. The feeder circuit of the electromagnetic-coupling module 1 is electromagnetically coupled with the shaft 411 or 416, and the electromagnetic-coupling module 1 communicates with a reader/writer of an RFID system. The seventeenth example is used for the above-described management of fixed asset and distribution management of articles, and can also be widely applied to other sports goods.

### (Eighteenth example See Fig. 54)

In an eighteenth example, as shown in Fig. 54, the electromagnetic-coupling module 1 is bonded to a radiation plate 421 provided on clothes 420 by using a conductive paint as a part of the design. The feeder circuit of the electromagnetic-coupling module 1 is electromagnetically coupled with the radiation plate 421, and the electromagnetic-coupling module 1 communicates with a reader/writer of an RFID system. The manufacture number, the manufacture date, the price, and the like of the clothes 420 are stored in the wireless IC chip, and the eighteenth example is used for management of fixed asset and distribution management of articles.

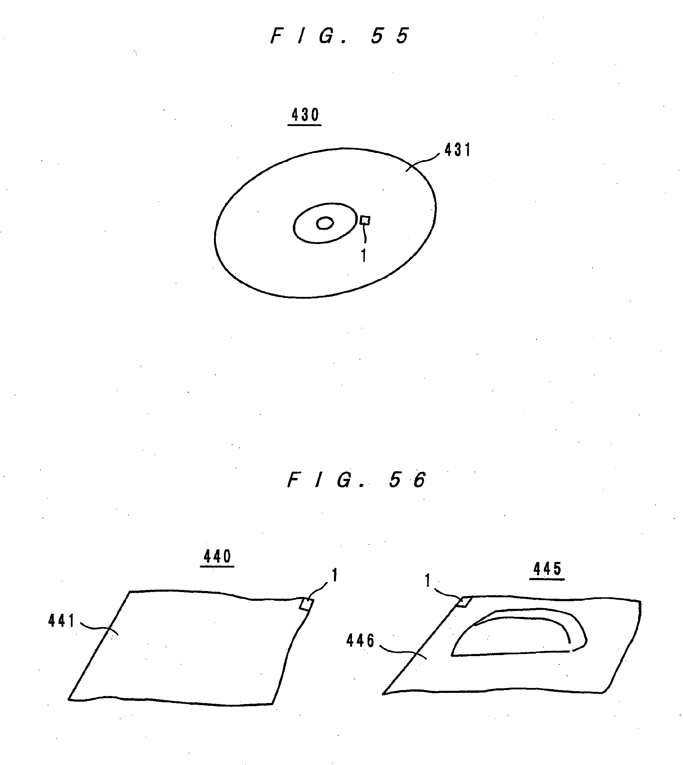

### (Nineteenth example, See Fig. 55)

In a nineteenth example, as shown in Fig. 55, an aluminum film 431 deposited on a recording medium 430, such as a DVD or a CD, is used as a radiation plate. The feeder circuit of the electromagnetic-coupling module 1 is electromagnetically coupled with the aluminum film 431, and the electromagnetic-coupling module 1 communicates with a reader/writer of an RFID system.

The nineteenth example is used for asset management and distribution management. In the nineteenth example, also, by using a player which inhibits a replay without receiving information from a wireless IC chip attached to the medium, the electromagnetic-coupling module 1 can also be used for prevention of illegal copying.

### (Twentieth example, See Fig. 56)

In a twentieth example, as shown in Fig. 56, an aluminum film 441 or 446 of a package 440 or 445 of a medical product is used as a radiation plate. The package 440 is for a granule of medicine, and the package 445 is for a tablet of medicine. The feeder circuit of the electromagnetic-coupling module 1 is electromagnetically coupled with the aluminum film 441 or 446, and the electromagnetic-coupling module 1 communicates with a reader/writer of an RFID system. In the twentieth example, the manufacture date, the components, the method for administering the medicine, the directions for taking the medicine, and the like of a medical product are stored in the wireless IC chip. Thereby, the twentieth example is used for asset management and distribution management of medical products, and also, it is possible to discriminate authorized medicine and unauthorized medicine from each other in a package-by-package manner.

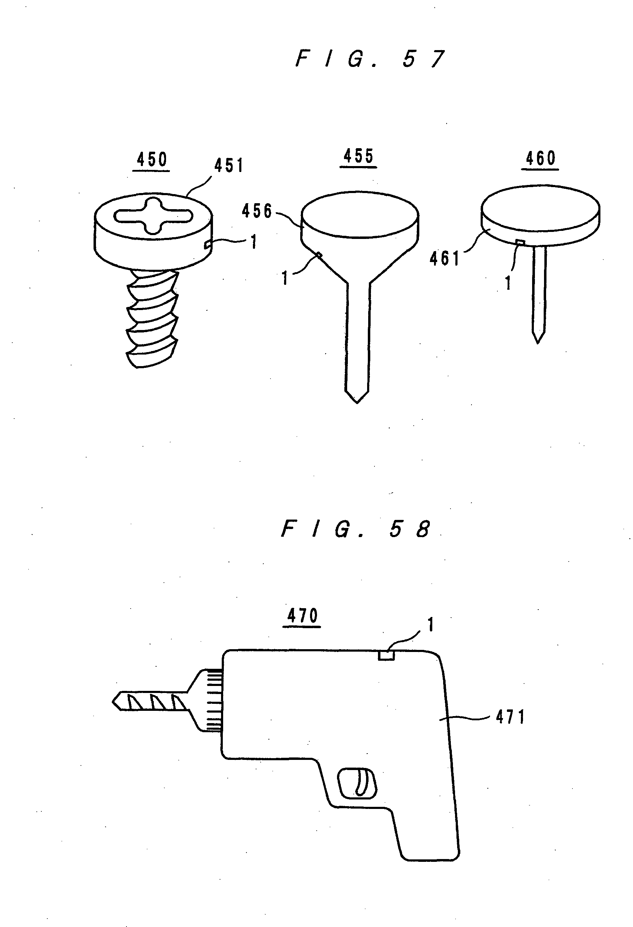

### (Twenty-First example, See Fig. 57)

In a twenty-first example, as shown in Fig. 57, a metal screw 450, a metal nail 455, or a metal pin 460 itself is used as a radiation plate. The electromagnetic-coupling module 1 is mounted to a head part 451, 456 or 461 of the screw 450, the nail 455 of the pin 460. The feeder circuit of the electromagnetic-coupling module 1 is electromagnetically coupled with the screw 450, the nail 455, or the pin 460, and the electromagnetic-coupling module 1 communicates with a reader/writer of an RFID system. In the twenty-first example, the electromagnetic-coupling module 1 can be used for asset management of the screw 450 and the like. If the screw 450 is a screw for precise construction, such as for assembly of an airplane, a fastening torque, a construction period, a construction method, and the like may be stored in the wireless IC chip so as to be managed.

### (Twenty-Second example, See Fig. 58)

In a twenty-second example, as shown in Fig. 58, a metal body 471 of a power tool 470 is used as a radiation plate. The feeder circuit of the electromagnetic-coupling module 1 is electromagnetically coupled with the body 471, and the electromagnetic-coupling module 1 communicates with a reader/writer of an RFID system. In the twenty-second example, the electromagnetic-coupling module 1 can be used for asset management and distribution management of the power tool 470 and other tools. Also, the electromagnetic-coupling module 1 can be used for management of each tool inside a tool box.

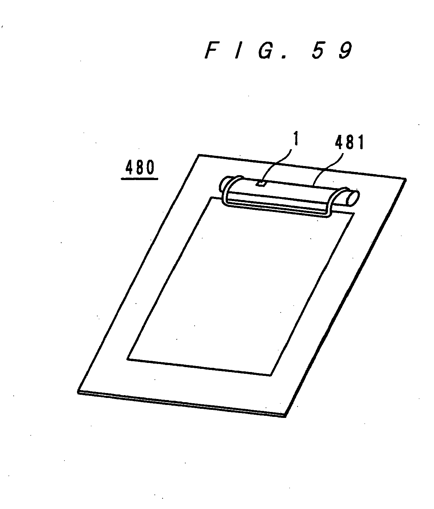

### (Twenty-Third example, See Fig. 59)

In a twenty-third example, as shown in Fig. 59, metal fittings 481 of a clipboard 480 is used as a radiation plate. The feeder circuit of the electromagnetic-coupling module 1 is electromagnetically coupled with the metal fittings 481, and the electromagnetic-coupling module 1 communicates with a reader/writer of an RFID system. In the twenty-third example, the electromagnetic-coupling modules 1 are used for asset management and distribution management of the clipboard 480 and other stationeries. Also, by communication between each of the electromagnetic-coupling modules 1 bonded to the clipboard 480 and other stationeries and the electromagnetic-coupling module 1 provided for a cabinet, storage management and storage position management inside a cabinet is possible.

In particular, the electromagnetic-coupling module can be mounted to various kinds of articles as well as the articles described in connection with the embodiments above. Furthermore, details of the internal configuration of the feeder circuit board and the shape of the radiation plate can be arbitrarily designed. In order to connect a wireless IC chip to a feeder circuit board, processing other than soldering may be used.

### Industrial Applicability

As has been described, the present invention is useful for an article with an electromagnetic-coupling module having a wireless IC chip used in an RFID system, and is excellent in that an article with an electromagnetic-coupling module having a wireless IC chip and having stable frequency characteristics can be obtained.

## Claims

1. An article with a feeder circuit board (10) and a wireless IC chip (5), comprising an article, a feeder circuit board (10) and a wireless IC chip (5) attached to the article, wherein
the article comprises a radiation plate (20);
the feeder circuit board (10) contains a feeder circuit (16) that includes a resonance circuit having a predetermined resonance frequency;
the wireless IC chip (5) is electrically connected to the feeder circuit (16);
the radiation plate (20) is configured to radiate a transmission signal supplied from the feeder circuit (16) via electromagnetic coupling and/or to supply a received reception signal to the feeder circuit (16) via electromagnetic coupling; and
**characterized in that**
the radiation plate is a metal housing (261) of a mobile phone (260).

2. The article according to Claim 1, wherein:
the feeder circuit (16) includes a coil-shaped electrode pattern;
the radiation plate (20) has an opening; and
the feeder circuit (16) is placed such that a magnetic flux of the coil-shaped electrode pattern passes through the opening.

3. The article according to Claim 1, wherein:
the feeder circuit (16) includes a coil-shaped electrode pattern consisting an inductance element; and
the inductance element has a winding axis perpendicular to the radiation plate (20).

4. The article according to Claim 1, wherein the housing of the mobile phone (260) comprises a metal housing part or a conductive paint if the housing is non metal.

5. The article according to Claim 1, wherein the resonance circuit is a lumped-constant resonance circuit formed of a capacitor element (C1, C2) and an inductor element (L).

6. The article according to Claim 1, wherein the feeder circuit board (10) is a rigid board made of resin or ceramic.

7. The article according to Claim 1, wherein an electrical length of the radiation plate (20) is an integral multiple of a half wavelength of the resonance frequency.

8. The article according to Claim 1, wherein the wireless IC chip (5) is provided with a chip-side electrode pattern, the feeder circuit board (10) is provided with a first board-side electrode pattern (32; 42; 52; 75a, 75b), and the wireless IC chip (5) and the feeder circuit board (10) are directly connected electrically to each other by the chip-side electrode pattern and the first board-side electrode pattern (32; 42; 52; 75a, 75b).

9. The article according to Claim 1, wherein the wireless IC chip (5) is provided with a chip-side electrode pattern (87a, 87b), the feeder circuit board (10) is provided with a first board-side electrode pattern (86a, 86b), and the wireless IC chip (5) and the feeder circuit board (10) are connected to each other by capacitive coupling between the chip-side electrode pattern (87a, 87b) and the first board-side electrode pattern (86a, 86b).

10. The article according to Claim 1, wherein the wireless IC chip (5) is provided with a chip-side electrode pattern (99), the feeder circuit board (10) is provided with a first board-side electrode pattern (92a, 92b; 102a), and the wireless IC chip (5) and the feeder circuit board (10) are connected to each other by magnetic coupling between the chip-side electrode pattern (99) and the first board-side electrode pattern (92a, 92b; 102a).

11. The article according to Claim 1, wherein the feeder circuit board (10) is provided with a second board-side electrode pattern (72a, 72b), and the feeder circuit board (10) and the radiation plate (20) are connected to each other by capacitive coupling between the second board-side electrode pattern (72a, 72b) and the radiation plate (20).

12. The article according to Claim 1, wherein the feeder circuit board (10) is provided with a second board-side electrode pattern (82a, 82b), and the feeder circuit board (10) and the radiation plate (20) are coupled together by magnetic coupling between the second board-side electrode pattern (82a, 82b) and the radiation plate (20).

## Patentansprüche

1. Ein Gegenstand mit einer Zuführvorrichtungsleiterplatte (10) und einem Drahtlos-IC-Chip (5), mit einem Gegenstand, einer Zuführvorrichtungsleiterplatte (10) und einem Drahtlos-IC-Chip (5), der an dem Gegenstand angebracht ist, wobei
der Gegenstand eine Strahlungsplatte (20) aufweist;
die Zuführvorrichtungsleiterplatte (10) eine Zuführvorrichtungsschaltung (16) beinhaltet, die eine Resonanzschaltung mit einer vorbestimmten Resonanzfrequenz umfasst;
der Drahtlos-IC-Chip (5) elektrisch mit der Zuführvorrichtungsschaltung (16) verbunden ist;
die Strahlungsplatte (20) ausgebildet ist, um ein Sendesignal, das von der Zuführvorrichtungsschaltung (16) geliefert wird, über elektromagnetische Kopplung abzustrahlen und/oder ein empfangenes Empfangssignal über elektromagnetische Kopplung an die Zuführvorrichtungsschaltung (16) zu liefern; und
**dadurch gekennzeichnet, dass**
die Strahlungsplatte ein Metallgehäuse (261) eines Mobiltelefons (260) ist.

2. Der Gegenstand gemäß Anspruch 1, bei dem:
die Zuführvorrichtungsschaltung (16) eine spulenförmige Elektrodenstruktur umfasst;
die Strahlungsplatte (20) eine Öffnung aufweist; und
die Zuführvorrichtungsschaltung (16) derart platziert ist, dass ein Magnetfluss der spulenförmigen Elektrodenstruktur durch die Öffnung verläuft.

3. Der Gegenstand gemäß Anspruch 1, bei dem:
die Zuführvorrichtungsschaltung (16) eine spulenförmige Elektrodenstruktur umfasst, die ein Induktivitätselement umfasst; und
das Induktivitätselement eine Wicklungsachse aufweist, die senkrecht zu der Strahlungsplatte (20) ist.

4. Der Gegenstand gemäß Anspruch 1, bei dem das Gehäuse des Mobiltelefons (260) einen Metallgehäuseteil oder einen leitfähigen Anstrich aufweist, wenn das Gehäuse nicht metallisch ist.

5. Der Gegenstand gemäß Anspruch 1, bei dem die Resonanzschaltung eine Resonanzschaltung mit konzentrierten Elementen ist, die aus einem Kondensatorelement (C1, C2) und einem Induktorelement (L) gebildet ist.

6. Der Gegenstand gemäß Anspruch 1, bei dem die Zuführvorrichtungsleiterplatte (10) eine starre Platine ist, die aus Harz oder Keramik hergestellt ist.

7. Der Gegenstand gemäß Anspruch 1, bei dem eine elektrische Länge der Strahlungsplatte (20) ein ganzzahliges Vielfaches einer halben Wellenlänge der Resonanzfrequenz ist.

8. Der Gegenstand gemäß Anspruch 1, bei dem der Drahtlos-IC-Chip (5) mit einer chipseitigen Elektrodenstruktur versehen ist, die Zuführvorrichtungsleiterplatte (10) mit einer ersten platinenseitigen Elektrodenstruktur (32; 42; 52; 75a, 75b) versehen ist und der Drahtlos-IC-Chip (5) und die Zuführvorrichtungsleiterplatte (10) durch die chipseitige Elektrodenstruktur und die erste platinenseitige Elektrodenstruktur (32; 42; 52; 75a, 75b) direkt elektrisch miteinander verbunden sind.

9. Der Gegenstand gemäß Anspruch 1, bei dem der Drahtlos-IC-Chip (5) mit einer chipseitigen Elektrodenstruktur (87a, 87b) versehen ist, die Zuführvorrichtungsleiterplatte (10) mit einer ersten platinenseitigen Elektrodenstruktur (86a, 86b) versehen ist und der Drahtlos-IC-Chip (5) und die Zuführvorrichtungsleiterplatte (10) durch kapazitive Kopplung zwischen der chipseitigen Elektrodenstruktur (87a, 87b) und der ersten platinenseitigen Elektrodenstruktur (86a, 86b) miteinander verbunden sind.

10. Der Gegenstand gemäß Anspruch 1, bei dem der Drahtlos-IC-Chip (5) mit einer chipseitigen Elektrodenstruktur (99) versehen ist, die Zuführvorrichtungsleiterplatte (10) mit einer ersten platinenseitigen Elektrodenstruktur (92a, 92b; 102a) versehen ist und der Drahtlos-IC-Chip (5) und die Zuführvorrichtungsleiterplatte (10) durch magnetische Kopplung zwischen der chipseitigen Elektrodenstruktur (99) und der ersten platinenseitigen Elektrodenstruktur (92a, 92b; 102a) miteinander verbunden sind.

11. Der Gegenstand gemäß Anspruch 1, bei dem die Zuführvorrichtungsleiterplatte (10) mit einer zweiten platinenseitigen Elektrodenstruktur (72a, 72b) versehen ist und die Zuführvorrichtungsleiterplatte (10) und die Strahlungsplatte (20) durch kapazitive Kopplung zwischen der zweiten platinenseitigen Elektrodenstruktur (72a, 72b) und der Strahlungsplatte (20) miteinander verbunden sind.

12. Der Gegenstand gemäß Anspruch 1, bei dem die Zuführvorrichtungsleiterplatte (10) mit einer zweiten platinenseitigen Elektrodenstruktur (82a, 82b) versehen ist und die Zuführvorrichtungsleiterplatte (10) und die Strahlungsplatte (20) durch magnetische Kopplung zwischen der zweiten platinenseitigen Elektrodenstruktur (82a, 82b) und der Strahlungsplatte (20) miteinander gekoppelt sind.

## Revendications

1. Article pourvu d'une carte de circuit imprimé d'alimentation (10) et d'une puce de circuit intégré sans fil (5), comprenant un article, une carte de circuit imprimé d'alimentation (10) et une puce de circuit intégré sans fil (5) fixée à l'article, dans lequel
l'article comprend une plaque de rayonnement (20) ;
la carte de circuit imprimé d'alimentation (10) contient un circuit d'alimentation (16) qui comprend un circuit de résonance ayant une fréquence de résonance prédéterminée ;
la puce de circuit intégré sans fil (5) est connectée électriquement au circuit d'alimentation (16) ;
la plaque de rayonnement (20) est configurée de façon à rayonner un signal de transmission délivré en sortie par le circuit d'alimentation (16) via un couplage électromagnétique et/ou de façon à transmettre un signal de réception reçu au circuit d'alimentation (16) via un couplage électromagnétique ; et
**caractérisé en ce que**
la plaque de rayonnement est un logement métallique (261) d'un téléphone mobile (260).

2. Article selon la revendication 1, dans lequel :
le circuit d'alimentation (16) comprend un motif d'électrode en forme de bobine ;
la plaque de rayonnement (20) présente une ouverture ; et
le circuit d'alimentation (16) est placé de sorte qu'un flux magnétique du motif d'électrode en forme de bobine passe à travers l'ouverture.

3. Article selon la revendication 1, dans lequel :
le circuit d'alimentation (16) comprend un motif d'électrode en forme de bobine se composant d'un élément d'inductance ; et
l'élément d'inductance présente un axe d'enroulement perpendiculaire à la plaque de rayonnement (20).

4. Article selon la revendication 1, dans lequel le logement du téléphone mobile (260) comprend une partie de logement métallique ou une peinture conductrice si le logement est non métallique.

5. Article selon la revendication 1, dans lequel le circuit de résonance est un circuit de résonance à constantes localisées comprenant un élément condensateur (C1, C2) et un élément inducteur (L).

6. Article selon la revendication 1, dans lequel la carte de circuit imprimé d'alimentation (10) est une carte rigide faite en résine ou en céramique.

7. Article selon la revendication 1, dans lequel une longueur électrique de la plaque de rayonnement (20) est un entier multiple d'une demi-longueur d'onde de la fréquence de résonance.

8. Article selon la revendication 1, dans lequel la puce de circuit intégré sans fil (5) comprend un motif d'électrode sur le côté puce, la carte de circuit imprimé d'alimentation (10) comprend un premier motif d'électrode sur le côté carte (32 ; 42 ; 52 ; 75a, 75b) , et la puce de circuit intégré sans fil (5) et la carte de circuit imprimé d'alimentation (10) sont directement connectées électriquement l'une à l'autre par le motif d'électrode sur le côté puce et le premier motif d'électrode sur le côté carte (32 ; 42 ; 52 ; 75a, 75b).

9. Article selon la revendication 1, dans lequel la puce de circuit intégré sans fil (5) comprend un motif d'électrode sur le côté puce (87a, 87b), la carte de circuit imprimé d'alimentation (10) comprend un premier motif d'électrode sur le côté carte (86a, 86b), et la puce de circuit intégré sans fil (5) et la carte de circuit imprimé d'alimentation (10) sont connectées l'une à l'autre via un couplage capacitif entre le motif d'électrode sur le côté puce (87a, 87b) et le premier motif d'électrode sur le côté carte (86a, 86b).

10. Article selon la revendication 1, dans lequel la puce de circuit intégré sans fil (5) comprend un motif d'électrode sur le côté puce (99), la carte de circuit imprimé d'alimentation (10) comprend un premier motif d'électrode sur le côté carte (92a, 92b ; 102a), et la puce de circuit intégré sans fil (5) et la carte de circuit imprimé d'alimentation (10) sont connectées l'une à l'autre via un couplage magnétique entre le motif d'électrode sur le côté puce (99) et le premier motif d'électrode sur le côté carte (92a, 92b ; 102a).

11. Article selon la revendication 1, dans lequel la carte de circuit imprimé d'alimentation (10) comprend un second motif d'électrode sur le côté carte (72a, 72b), et la carte de circuit imprimé d'alimentation (10) et la plaque de rayonnement (20) sont connectées l'une à l'autre via un couplage capacitif entre le second motif d'électrode sur le côté carte (72a, 72b) et la plaque de rayonnement (20).

12. Article selon la revendication 1, dans lequel la carte de circuit imprimé d'alimentation (10) comprend un second motif d'électrode sur le côté carte (82a, 82b), et la carte de circuit imprimé d'alimentation (10) et la plaque de rayonnement (20) sont couplées ensemble via un couplage magnétique entre le second motif d'électrode sur le côté carte (82a, 82b) et la plaque de rayonnement (20).
